(19) Europäisches Patentamt
European Patent Office
Office européen des brevets

(11) **EP 2 329 596 B1**

(12) **FASCICULE DE BREVET EUROPEEN**

(45) Date de publication et mention
de la délivrance du brevet:
**25.01.2012   Bulletin 2012/04**

(51) Int Cl.:
***H03K 19/0175*** *(2006.01)*      ***H04N 5/232*** *(2006.01)*

(21) Numéro de dépôt: **09811098.4**

(86) Numéro de dépôt international:
**PCT/EP2009/060659**

(22) Date de dépôt: **18.08.2009**

(87) Numéro de publication internationale:
**WO 2010/026042 (11.03.2010 Gazette 2010/10)**

(54) **MODULE RECONFIGURABLE ET PROCEDE DE MISE EN OEUVRE DE CE MODULE RECONFIGURABLE POUR REALISER DES OPERATIONS MORPHOLOGIQUES**

**REKONFIGURIERBARES MODUL UND VERFAHREN ZUR IMPLEMENTIERUNG DIESES REKONFIGURIERBAREN MODULS ZUR AUSFÜHRUNG MORPHOLOGISCHER OPERATIONEN**

**RECONFIGURABLE MODULE AND METHOD FOR IMPLEMENTING SAID RECONFIGURABLE MODULE FOR CARRYING OUT MORPHOLOGICAL OPERATIONS**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité:  **05.09.2008   FR 0804890**

(43) Date de publication de la demande:
**08.06.2011   Bulletin 2011/23**

(73) Titulaire: **Commissariat à l'Énergie Atomique et aux Énergies Alternatives
75015 Paris (FR)**

(72) Inventeurs:
 • **GUIBERT, Mickael
   F-94170 Le Perreux-sur-Marne (FR)**
 • **SCHMIT, Renaud
   F-28700 Anneau (FR)**

(74) Mandataire: **Collet, Alain et al
Marks & Clerk France
Conseils en Propriété Industrielle
Immeuble " Visium "
22, avenue Aristide Briand
94117 Arcueil Cedex (FR)**

(56) Documents cités:
**JP-A- 2006 261 919      US-A1- 2005 195 420
US-A1- 2008 013 862**

**Description**

**DOMAINE DE L'INVENTION**

L'invention concerne un module reconfigurable et un procédé de mise en oeuvre de ce module reconfigurable permettant de réaliser des opérations morphologiques. En particulier, elle propose un unique module reconfigurable permettant de réaliser de façon optimisée un ensemble d'opérations morphologiques appliquées au traitement d'image. Le module reconfigurable permet notamment de déterminer, à partir d'une image originale, une image intégrale, une image érodée, une image dilatée, une image distance de Manhattan et des projections de l'image originale. L'invention s'applique notamment aux domaines de l'électronique embarquée tels que la vidéo pour la téléphonie mobile ou les systèmes d'aide à la conduite.

**CONTEXTE DE L'INVENTION - ART ANTERIEUR**

Les opérations morphologiques constituent les opérations de base du traitement d'image. Elles sont de ce fait très usitées dans le domaine du traitement d'image. Avec le développement des technologies du multimédia, en particulier l'augmentation des résolutions d'image associée à la miniaturisation des circuits électronique, il existe un besoin croissant d'optimisation de ces opérations morphologiques. A ce jour, des circuits intégrés à applications spécifiques, mieux connus sous le terme anglo-saxon "ASIC" pour "Application-Specific Integrated Circuit", permettent d'accélérer les opérations morphologiques. Cependant, un circuit ASIC, pris individuellement, permet uniquement d'accélérer une opération morphologique en particulier. Autrement dit, il n'existe pas de module ASIC pouvant accélérer matériellement plusieurs opérations morphologiques. Par ailleurs, concernant les opérations d'érosion et de dilatation, un circuit ASIC particulier ne peut réaliser ces opérations que pour un élément structurant de dimension prédéfinie, ou tout du moins, pour des éléments structurants de dimension inférieure à la dimension prédéfinie. Autrement dit, un circuit ASIC réalisant une opération d'érosion ou de dilatation par un élément structurant de dimension 3x3 ne peut pas réaliser cette opération d'érosion ou de dilatation par un élément structurant de dimension 5x5. Une solution à ces deux limitations consiste alors à utiliser une structure de calcul programmable telle qu'un ordinateur personnel. Cependant, une telle structure présente des performances bien plus faibles que celles des circuits ASIC. A titre d'exemple, au moins trois cycles par pixels sont nécessaires à l'obtention d'un résultat avec une structure programmable alors qu'un résultat peut être obtenu pour plusieurs pixels en un seul cycle avec certains circuits ASIC.

**PRESENTATION DE L'INVENTION**

Un but de l'invention est notamment de pallier tout ou partie des inconvénients précités en proposant un module reconfigurable permettant de réaliser plusieurs opérations morphologiques avec le meilleur compromis performance - flexibilité - surface de silicium. A cet effet, l'invention a pour objet un module reconfigurable comportant un bloc opérateur comprenant cinq entrées et trois sorties. La première sortie du bloc opérateur est apte à délivrer soit le résultat de l'addition de la première et de la deuxième entrée du bloc opérateur, soit le résultat de la soustraction de la deuxième entrée à la première entrée du bloc opérateur, soit le minimum de la première et de la deuxième entrée du bloc opérateur, soit le maximum de la première et de la deuxième entrée du bloc opérateur. La deuxième sortie du bloc opérateur est apte à délivrer soit le résultat de l'addition de la quatrième et de la cinquième entrée du bloc opérateur, soit le résultat de la soustraction de la cinquième entrée à la quatrième entrée du bloc opérateur, soit le minimum de la quatrième et de la cinquième entrée du bloc opérateur, soit le maximum de la quatrième et de la cinquième entrée du bloc opérateur, soit le minimum de la première, de la deuxième et de la quatrième entrée du bloc opérateur, soit le maximum de la première, de la deuxième et de la quatrième entrée du bloc opérateur. La troisième sortie du bloc opérateur est apte à délivrer soit le résultat de l'addition de la première sortie et de la troisième entrée du bloc opérateur, soit le résultat de la soustraction de la troisième entrée à la première sortie du bloc opérateur.

L'invention a notamment pour avantage qu'elle permet de réaliser, avec un unique module et de façon optimisée, les opérations d'intégration, d'érosion, de dilatation, de distance de Manhattan et de projection. Les opérations d'érosion et de dilatation peuvent en outre être réalisées avec des éléments structurants de dimension supérieure à 3x3 en chaînant les modules reconfigurables.

L'invention a également pour objet un procédé de mise en oeuvre du module reconfigurable décrit ci-dessus. Selon l'invention, le procédé comprend une étape consistant à déterminer, à partir d'une image originale comprenant M lignes et N colonnes de pixels p(m,n), M et N étant des entiers positifs, soit une image intégrale, soit une image érodée, soit une image dilatée, soit une image distance de Manhattan, soit une projection suivant les lignes et une projection suivant les colonnes de l'image originale. Le type d'image finale peut être déterminé en fonction du type d'opérations effectuées par des additionneurs/soustracteurs appartenant au bloc opérateur et de liaisons établies entre des entrées et des sorties de blocs logiques appartenant au bloc opérateur. L'image intégrale, l'image érodée, l'image dilatée et l'image distance de Manhattan ont la même dimension que l'image originale.

## DESCRIPTION DES FIGURES

L'invention sera mieux comprise et d'autres avantages apparaîtront à la lecture de la description détaillée d'un mode de réalisation donné à titre d'exemple, description faite en regard de dessins annexés qui représentent :

- la figure 1a, un exemple d'image originale ;
- la figure 1b, une image intégrale associée à l'image originale de la figure 1 a ;
- la figure 2, une illustration du principe de calcul du poids d'un ensemble de pixels à partir d'une image intégrale ;
- la figure 3a, un deuxième exemple d'image originale ;
- la figure 3b, une image intermédiaire obtenue par une première étape de l'opération d'intégrale image selon l'invention à partir de l'image originale de la figure 3a ;
- la figure 3c, une image intégrale obtenue par une seconde étape de l'opération d'intégrale image selon l'invention à partir de l'image intermédiaire de la figure 3b ;
- la figure 4, une illustration du principe de détermination d'une image érodée et d'une image dilatée à partir d'un troisième exemple d'image originale ;
- la figure 5, une illustration de la décomposition d'un élément structurant en deux sous-éléments ;
- la figure 6a, une illustration du principe de détermination d'une image intermédiaire obtenue par une première étape de l'opération d'érosion selon l'invention à partir d'un quatrième exemple d'image originale ;
- la figure 6b, une illustration du principe de détermination d'une image érodée obtenue par une seconde étape de l'opération d'érosion selon l'invention à partir de l'image intermédiaire de la figure 6a ;
- la figure 7, un cinquième exemple d'une image originale binarisée et d'une image distance qui lui est associée ;
- la figure 8, une illustration du principe de détermination de l'image distance à partir de l'image originale binarisée de la figure 7 ;
- la figure 9, des sous-étapes de l'opération distance city-block selon l'invention permettant d'obtenir une image intermédiaire à partir d'une image originale binarisée ;
- la figure 10, un exemple d'image originale binarisée et une image intermédiaire obtenue à partir des sous-étapes de la figure 9 ;
- la figure 11, des sous étapes de l'opération distance city-block selon l'invention permettant d'obtenir une image distance à partir d'une image intermédiaire ;
- la figure 12, l'image intermédiaire de la figure 10 et une image distance obtenue à partir des sous-étapes de la figure 11 ;
- la figure 13, une illustration de l'opération de projection ;
- la figure 14, un exemple de bloc opérateur ;
- la figure 15, un module reconfigurable comprenant le bloc opérateur de la figure 14 ;
- la figure 16, un exemple de chaînage de deux modules reconfigurables selon la figure 15.

## DESCRIPTION DETAILLEE

### Description des opérations morphologiques

Pour la suite de la description, on considère des images matricielles, autrement dit des images composées de pixels répartis en lignes et en colonnes. D'un point de vue géométrique, les pixels sont assimilés à des rectangles de taille semblable. Un pixel $p(m,n)$ est repéré par rapport à un point d'origine O par son appartenance à une ligne m et à une colonne n, m et n étant des entiers compris entre 1 et, respectivement, le nombre M de lignes et le nombre N de colonnes de l'image. On considère en outre des images rectangulaires, c'est-à-dire comportant le même nombre de pixels $p(m,n)$ pour chaque ligne.

### *Intégration*

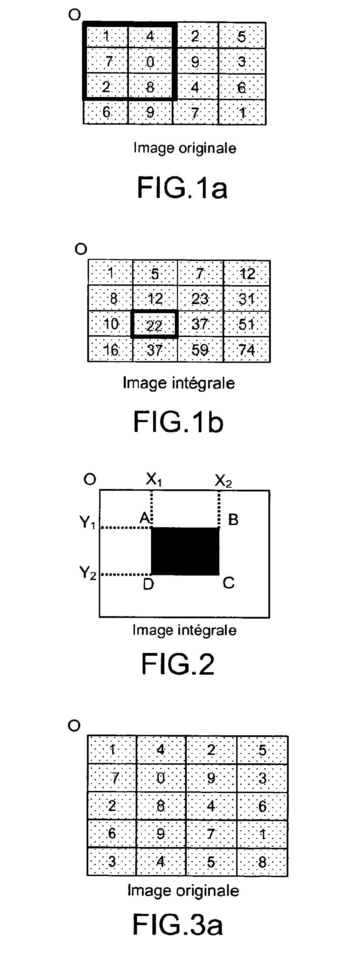

Les figures 1a et 1 b illustrent le principe d'une première opération morphologique, appelée intégration. La figure 1a représente une image, appelée image originale, composée de quatre lignes (M=4) et de quatre colonnes (N=4) de pixels $p(m,n)$, soit seize pixels $p(m,n)$. A chaque pixel $p(m,n)$ de l'image originale est associée une valeur scalaire appelée poids $wo(m,n)$. Pour une image codée sur huit bits, le poids $wo(m,n)$ peut alors être compris entre les valeurs 0 et 255. L'opération d'intégrale image consiste à déterminer une image dite image intégrale, de même taille que l'image originale, pour laquelle le poids $wi(m,n)$ de chaque pixel $p(m,n)$ est déterminé à partir de la somme des poids $wo(m,n)$ de tous les pixels $p(x,y)$ situés dans la surface rectangulaire délimitée par l'origine O et le pixel $p(m,n)$ considéré.

L'opération d'intégrale image peut être modélisée par la relation :

$$\forall (m,n) \in [1,M] \times [1,N], \, wi(m,n) = \sum_{x=1}^{m} \sum_{y=1}^{n} wo(x,y) \qquad (1)$$

L'image intégrale ainsi obtenue est représentée à la figure 1 b.

A partir de l'image intégrale, il est possible d'accélérer le calcul de la somme des poids wo(m,n) de n'importe quel groupe de pixels p(m,n). Un tel groupe de pixels p(m,n) est appelé surface. La figure 2 illustre le principe de calcul du poids d'un rectangle ABCD. De manière évidente, le poids W de la surface ABCD peut être obtenu, à partir de l'image intégrale, par une addition et deux soustractions selon la relation suivante :

$$W = A - B + C - D \qquad (2)$$

L'utilisation de l'image intégrale permet d'éviter d'additionner tous les poids wo(m,n) des pixels p(m,n) appartenant à la surface ABCD. Elle présente un intérêt particulier lorsque plusieurs surfaces doivent être calculées pour une même image et que la résolution de l'image est importante.

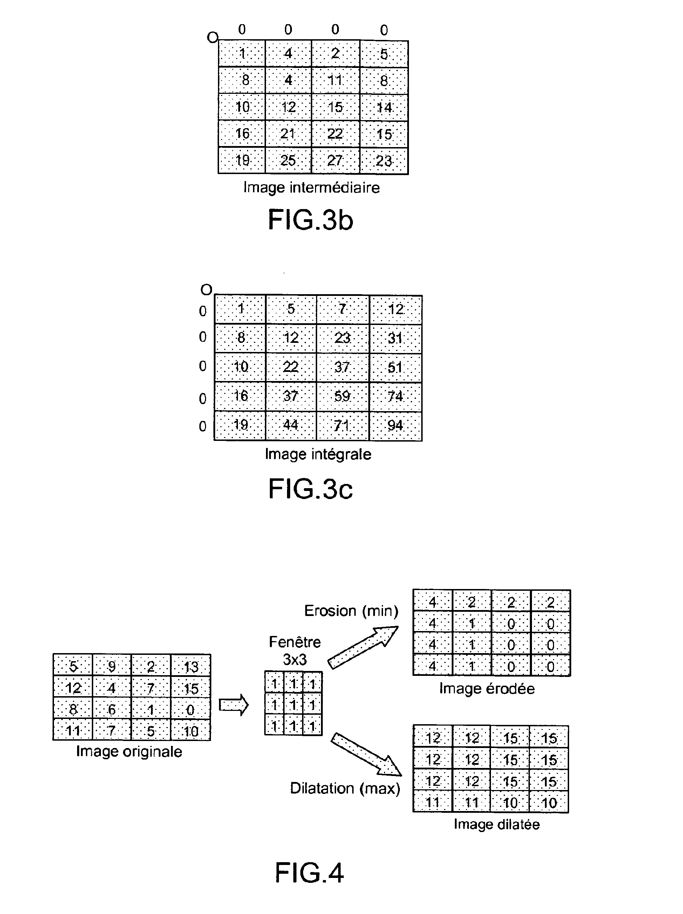

Selon l'invention, l'intégrale image est déterminée en deux étapes, une première étape déterminant une image intermédiaire à partir de l'image originale et une seconde étape déterminant l'image intégrale à partir de l'image intermédiaire. L'image intermédiaire a, comme l'image intégrale, la même taille que l'image originale. Un exemple d'image originale est représenté à la figure 3a. Le poids wii(m,n) des pixels p(m,n) de l'image intermédiaire est déterminé de proche en proche en additionnant au poids wo(m,n) du pixel p(m,n) considéré dans l'image originale le poids wii(m-1,n) du pixel p(m-1,n) de l'image intermédiaire situé sur la même colonne à la ligne précédente. Le résultat de l'image intermédiaire est illustré à la figure 3b. Le poids wi(m,n) des pixels p(m,n) de l'image intégrale est alors déterminé, toujours de proche en proche, en additionnant au poids wii(m,n) du pixel p(m,n) considéré dans l'image intermédiaire le poids wi(m,n-1) du pixel p(m,n-1) de l'image intégrale situé sur la même ligne à la colonne précédente. Le résultat de l'image intégrale est illustré à la figure 3c. La détermination des poids wii(m,n) de l'image intermédiaire et des poids wi(m,n) de l'image intégrale peut être modélisée par l'algorithme suivant :

POUR m variant de 1 à M, FAIRE :

POUR n variant de 1 à N, FAIRE :

$$wii(m,n) = wo(m,n) + wii(m-1,n) \qquad (3)$$

Fin POUR

Fin POUR

POUR m variant de 1 à M, FAIRE :

POUR n variant de 1 à N, FAIRE :

$$wi(m,n) = wii(m,n) + wi(m,n-1) \qquad (4)$$

Fin POUR

Fin POUR

Les cas particuliers de la première ligne (m=1) et de la première colonne (n=1) peuvent être facilement traités en considérant une ligne et une colonne dites d'initialisation. La ligne d'initialisation (m=0) peut être insérée avant la première ligne (m=1) de l'image intermédiaire. Les poids wii(0,n) de tous les pixels p(0,n) de cette ligne d'initialisation sont fixés à la valeur nulle, de sorte que les poids wii(1,n) des pixels p(1,n) de la première ligne (m=1) de l'image intermédiaire sont égaux aux poids wo(1,n) des mêmes pixels p(1,n) de l'image originale. Par ailleurs, la colonne d'initialisation (n=0) peut être insérée avant la première colonne (n=1) de l'image intégrale. Les poids wi(m,0) de tous les pixels p(m,0) de cette colonne d'initialisation sont fixés à la valeur nulle, de sorte que les poids wi(m,1) des pixels p(m,1) de la première colonne (n=1) de l'image intégrale sont égaux aux poids wii(m,1) des mêmes pixels p(m,1) de l'image intermédiaire. Selon une autre forme de réalisation, le cas particulier de la première ligne (m=1) est traité en initialisant les poids wii(1,n) des pixels p(1,n) de la première ligne (m=1) de l'image intermédiaire aux mêmes valeurs que les poids wo(1,n) des pixels p(1,n) de la première ligne (m=1) de l'image originale, et le cas particulier de la première colonne (n=1) est traité en initialisant les poids wi(m,1) des pixels p(m,1) de la première colonne (n=1) de l'image intégrale aux mêmes valeurs que les poids wii(m,1) des pixels p(m,1) de la première colonne (n=1) de l'image intermédiaire. Les relations 3 et 4 de l'algorithme précédent sont alors déterminées pour m variant de 2 à M et pour n variant de 2 à N.

La description précédente est faite en considérant que l'image intermédiaire est obtenue en additionnant ligne par ligne les poids wo(m,n) et wii(m-1,n) des pixels p(m,n) et p(m-1,n) de l'image originale et de l'image intermédiaire et que l'image intégrale est obtenue en additionnant colonne par colonne les poids wii(m,n) et wi(m,n-1) des pixels p(m,n) et p(m,n-1) de l'image intermédiaire et de l'image intégrale. Bien évidemment, il est possible d'inverser les additions ligne par ligne avec les additions colonne par colonne en considérant les ligne et colonne d'initialisation appropriées. L'algorithme devient alors :

POUR n variant de 1 à N, FAIRE :

POUR m variant de 1 à M, FAIRE :

$$wii(m,n) = wo(m,n) + wii(m,n-1) \qquad (3')$$

Fin POUR

Fin POUR
POUR n variant de 1 à N, FAIRE :

POUR m variant de 1 à M, FAIRE :

$$wi(m,n) = wii(m,n) + wi(m-1,n) \qquad (4')$$

Fin POUR

Fin POUR

### Erosion - dilatation

La figure 4 illustre le principe de deux autres opérations morphologiques, appelées érosion et dilatation. Ces deux opérations morphologiques sont similaires dans leur réalisation. Dans le cadre d'une image monochrome noir et blanc, l'opération d'érosion est notamment utilisée pour supprimer les pics de niveaux de gris et pour "agrandir les trous", alors que l'opération de dilatation est utilisée pour élargir les pics de niveaux de gris et pour "boucher les trous". Ces opérations font appel à une fenêtre de travail, également appelée élément structurant, formée d'une maille de pixels. Cette maille peut être carrée, rectangulaire ou hexagonale. Sur la figure 4 sont représentés un exemple d'image originale composée de quatre lignes (M=4) et de quatre colonnes (N=4) de pixels p(m,n) ainsi que les images érodées et dilatées obtenues pour cette image originale après, respectivement, une opération d'érosion et une opération de dilatation par un élément structurant de taille 3x3. L'opération d'érosion consiste à déterminer, pour chaque pixel p(m,n) de l'image originale, un poids we(m,n) correspondant au minimum des poids wo(x,y) des pixels p(x,y) appartenant à l'élément structurant centré sur le pixel p(m,n) considéré. Inversement, l'opération de dilatation consiste à déterminer, pour chaque pixel p(m,n) de l'image originale, un poids wf(m,n) correspondant au maximum des poids wo(x,y) des pixels p(x,y) appartenant à l'élément structurant centré sur le pixel p(m,n) considéré.

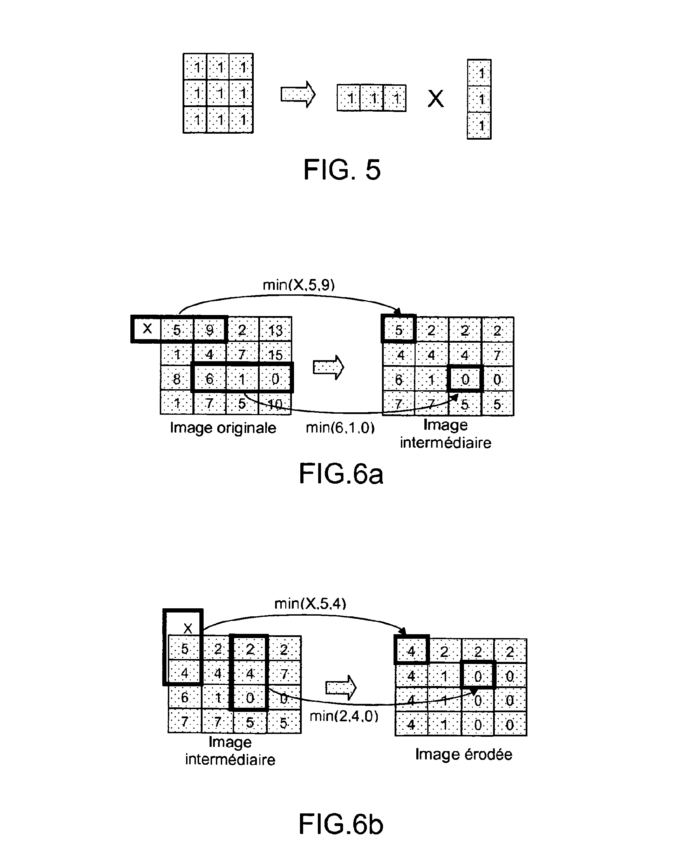

Selon l'invention, les opérations d'érosion et de dilatation sont chacune déterminées à partir de deux étapes, une première étape déterminant une image intermédiaire à partir de l'image originale et une seconde étape déterminant l'image érodée ou dilatée à partir de l'image intermédiaire. Pour ce faire, l'élément structurant de taille PxQ est décomposé en deux sous-éléments, un premier sous-élément de taille 1xQ et un second sous-élément de taille Px1, comme représenté à la figure 5. L'image intermédiaire est alors déterminée en balayant, c'est-à-dire en déplaçant de pixel en pixel, le premier sous-élément sur chaque ligne de l'image originale. L'image érodée ou dilatée est quant à elle déterminée en balayant le second sous-élément sur chaque colonne de l'image intermédiaire. La suite de la description est faite en considération de l'opération d'érosion pour une image originale telle que représentée à la figure 6a et un élément structurant de taille 3x3. Dans la première étape, représentée à la figure 6a, le poids wie(m,n) des pixels p(m,n) de l'image intermédiaire est déterminé en considérant le minimum des poids wo(m,n-1), wo(m,n) et wo(m,n+1) des pixels p(m,n-1), p(m,n) et p(m,n+1) de l'image originale. Dans la deuxième étape, représentée à la figure 6b, le poids we(m, n) des pixels p(m,n) de l'image érodée est déterminé en considérant le minimum des poids wie(m-1,n), wie(m,n) et wie (m+1,n) des pixels p(m-1,n), p(m,n) et p(m+1,n) de l'image intermédiaire. La détermination des poids wie(m,n) de l'image intermédiaire et des poids we(m,n) de l'image érodée peut être modélisée par les relations suivantes :

$$\forall (m,n) \in [1,M] \times [1,N],$$
$$wie(m,n) = \min[wo(m,n-1), wo(m,n), wo(m,n+1)] \qquad (5)$$

$$we(m,n) = \min[wie(m-1,n), wie(m,n), wie(m+1,n)] \qquad (6)$$

Les cas particuliers de la première et de la dernière ligne (m=1 et m=M) et de la première et de la dernière colonne (n=1 et n=N) peuvent être facilement traités en considérant des lignes et des colonnes dites d'encadrement. Les lignes d'encadrement (m=0 et m=M+1) peuvent être insérées avant la première ligne (m=1) et après la dernière ligne (m=M) de l'image originale. Les poids wo(0,n) et wo(M+1,n) de tous les pixels p(0,n) et p(M+1,n) de ces lignes d'encadrement sont par exemple fixés à la plus grande valeur (dans le cadre d'une érosion) que peuvent prendre les poids wo(m,n) des pixels p(m,n) de l'image originale, par exemple 255. Par ailleurs, les colonnes d'encadrement (n=0 et n=N+1) peuvent être insérées avant la première colonne (n=1) et après la dernière colonne (n=N+1) de l'image intermédiaire. Les poids wie(m,0) et wie(m,N+1) de tous les pixels p(m,0) et p(m,n+1) sont par exemple fixés à la plus grande valeur que peuvent prendre les poids wie(m,n) des pixels p(m,n) de l'image intermédiaire, par exemple 255. Selon une autre forme de réalisation, les cas particuliers de la première et de la dernière ligne (m=1 et m=M) et de la première et de la dernière colonne (n=1 et n=N) peuvent être traités en ne considérant pas les lignes et les colonnes situées en dehors de l'image originale et de l'image intermédiaire. En d'autres termes, les sous-éléments de l'élément structurant sont réduits au niveau des bords de l'image.

Bien évidemment, les première et deuxième étapes de l'opération d'érosion peuvent être inversées, l'image intermédiaire étant alors obtenue par des minimums sur des colonnes au lieu de minimums sur des lignes.

L'opération de dilatation peut être facilement obtenue en adaptant l'opération d'érosion, notamment en remplaçant les opérations de minimum par des opérations de maximum. Les cas particuliers des première et dernière lignes et première et dernière colonnes peuvent alors être traités en fixant la valeur des poids concernés à la valeur nulle.

### Distance de Manhattan

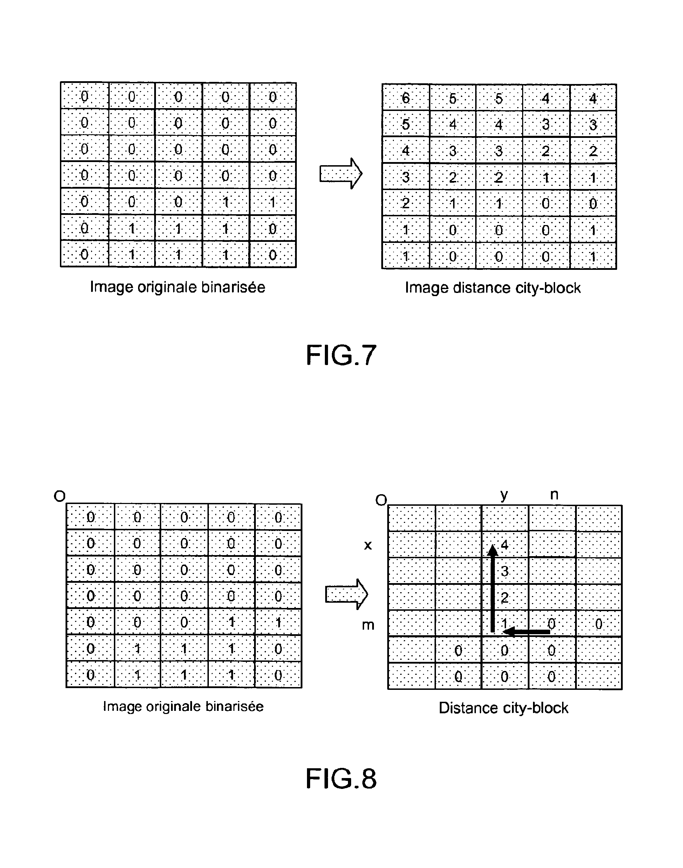

Les figures 7 et 8 illustrent le principe de l'opération distance de Manhattan, également connue dans la littérature anglo-saxonne sous le terme de distance "city-block". Cette opération permet de déterminer la distance d'un objet de l'image par rapport à tout point de l'image. Pour cette opération, il est nécessaire de partir d'une image originale binarisée, c'est-à-dire d'une image composée de pixels dont les poids ne peuvent prendre que deux valeurs, une première valeur correspondant à un état haut, par exemple '1', et une seconde valeur correspondant à un état bas, par exemple '0'. L'image originale binarisée peut être obtenue par seuillage. Les pixels de l'image originale binarisée correspondant à l'objet ont par exemple un poids fixé à l'état haut, les autres pixels ayant un poids fixé à l'état bas. L'image obtenue par l'opération distance de Manhattan, appelée image distance, est une image dont le poids wd(m,n) de chaque pixel p(m, n) est égal à la distance de Manhattan entre le pixel p(m,n) considéré et le pixel p(x,y) le plus proche du pixel p(m,n) considéré appartenant à l'objet. La figure 7 illustre un exemple d'image originale binarisée et l'image distance correspondante. Par distance D de Manhattan entre deux pixels p(m,n) et p(x,y), on entend la somme de la différence, en valeur absolue, entre la ligne m du pixel p(m,n) et la ligne x du pixel p(x,y) et de la différence, en valeur absolue, entre la colonne n du pixel p(m,n) et la colonne y du pixel p(x,y), selon la relation :

$$D = |m - x| + |n - y| \qquad (7)$$

La figure 8 illustre le calcul du poids wd(2,3) du pixel p(2,3) de l'image distance. L'un des pixels les plus proches du pixel p(2,3) appartenant à l'objet est le pixel p(5,4). Le poids wd(2,3) du pixel p(2,3) peut ainsi être déterminé par la relation :

$$wd(2,3) = D = |2 - 5| + |3 - 4| = 4 \, .$$

Il peut être noté que tout autre chemin entre l'objet et le pixel p(m,n) considéré conduirait à la même distance de Manhattan, et donc au même poids wd(m,n).

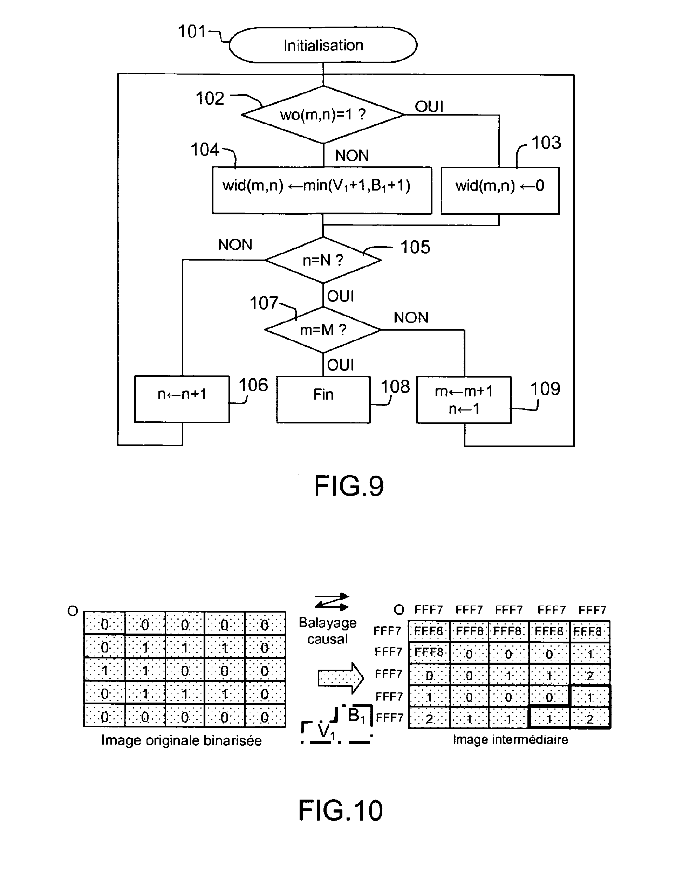

Selon l'invention, l'opération distance de Manhattan est, comme les autres opérations morphologiques selon l'invention, déterminée en deux étapes. Une première étape détermine une image intermédiaire à partir de l'image originale, en l'occurrence l'image originale binarisée et une seconde étape détermine l'image distance à partir de l'image intermédiaire. Dans la première étape, un élément structurant en forme de 'L' renversé (figure 10) d'un quart de tour dans le sens trigonométrique et composé de trois pixels p(m,n-1), p(m,n) et p(m-1,n) est balayé successivement sur chaque ligne de l'image originale en partant du pixel p(1,1). Dans le cas où le pixel central p(m,n) appartient à l'objet, le poids wid(m,n) de ce même pixel p(m,n) dans l'image intermédiaire est fixé à zéro. Dans le cas contraire, le poids wid(m,n) du pixel central p(m,n) de l'image intermédiaire est déterminé en comparant le poids $V_1$=wid(m,n-1) du pixel p(m,n-1) de l'image intermédiaire situé sur la même ligne (m) à la colonne précédente (n-1) au poids $B_1$=wid(m-1,n) du pixel p(m-1,n) de l'image intermédiaire situé à la ligne précédente (m-1) sur la même colonne (n). Le poids wid(m,n) du pixel central p(m,n) de l'image intermédiaire est alors égal au minimum des poids $V_1$ et $B_1$ incrémentés d'une unité, conformément à la relation :

$$wid(m,n) = \min(V_1 + 1, B_1 + 1) \, . \qquad (8)$$

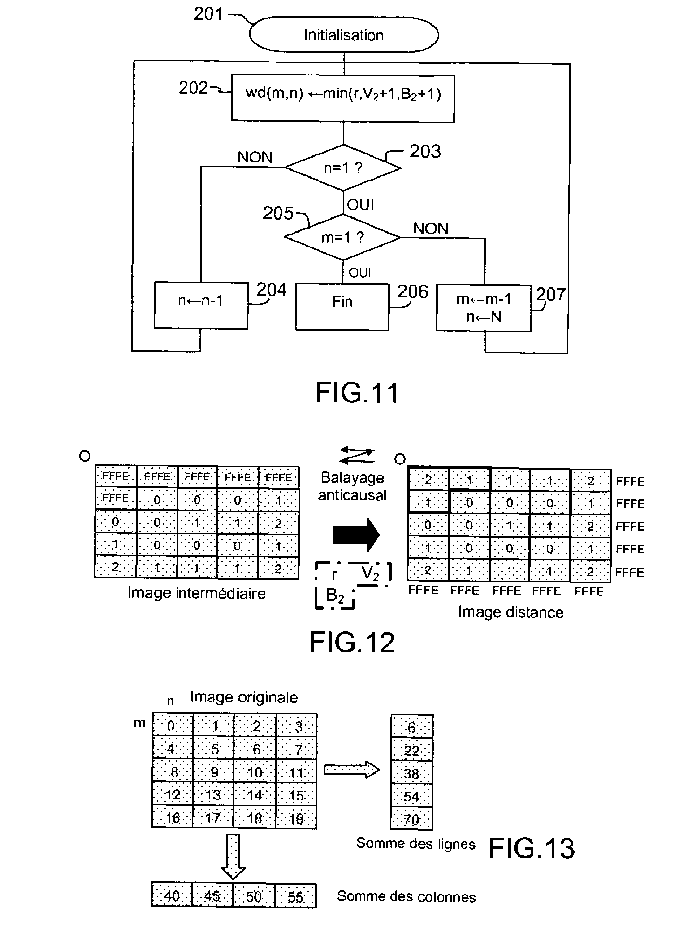

Dans la seconde étape, un élément structurant, toujours en forme de 'L', (figure 12) mais renversé d'un quart de tour dans le sens anti-trigonométrique et composé de trois pixels p(m+1,n), p(m,n) et p(m,n+1) est balayé successivement sur chaque ligne de l'image intermédiaire en partant du pixel p(M,N). Le poids wd(m,n) du pixel central p(m,n) de l'image distance est alors déterminé en comparant le poids r=wid(m,n) du pixel p(m,n) de l'image intermédiaire, le poids $B_2$=wd(m+1,n) du pixel p(m+1,n) de l'image distance et le poids $V_2$=wd(m,n+1) du pixel p(m,n+1) de l'image distance. Le poids wd(m,n) du pixel central p(m,n) de l'image distance est alors égal au minimum des poids r, $B_2$+1 et $V_2$+1, conformément à la relation :

$$wd(m,n) = \min(r, B_2 + 1, V_2 + 1) \, . \qquad (9)$$

Selon une forme particulière de réalisation, on vérifie également dans la seconde étape si le pixel central p(m,n) appartient à l'objet. Dans le cas où le pixel central p(m,n) appartient à l'objet, le poids wd(m,n) de ce même pixel p(m,n) dans l'image distance est fixé à zéro. Dans le cas contraire, le poids wd(m,n) du pixel p(m,n) est déterminé par la relation 9. Cette forme particulière de réalisation permet de conformer la seconde étape à la première.

La figure 9 illustre des sous-étapes de la première étape. Dans une première sous-étape, appelée étape d'initialisation 101, une ligne d'initialisation (m=0) et une colonne d'initialisation (n=0) sont insérées, respectivement, avant la première ligne (m=1) et avant la première colonne (n=1) de l'image intermédiaire. Les poids wid(0,n) et wid(m, 0) des pixels p(0,n) et p(m,0) de la ligne d'initialisation (m=0) et de la colonne d'initialisation (n=0) sont fixés par rapport à une valeur de référence Vréf et à un nombre Nmax de pixels p(m,n), ce nombre Nmax correspondant à la distance maximale entre un pixel p(m,n) donné et un objet de l'image. Le nombre Nmax peut être déterminé par la relation suivante :

$$Nmax = (N-1) + (M-1)$$

La valeur de référence Vréf est déterminée afin d'être supérieure au nombre Nmax. Elle correspond par exemple à la valeur maximale d'un registre. Dans le cadre d'images de résolution VGA, Vréf peut être fixé à la valeur 2048, soit un registre de 11 bits. Dans le cadre d'images de résolution dite "full HD", c'est-à-dire comprenant une matrice de 1920*1080 pixels, Vréf peut être fixé à 4096, soit un registre de 12 bits.

Les poids wid(0,n) et wid(m,0) peuvent être égaux à la valeur de référence Vréf moins le nombre Nmax, conformément aux relations :

$$\forall n \in [1, N], \text{wid}(0, n) = \text{Vréf} - \text{Nmax} \qquad (10a)$$

$$\forall m \in [1, M], \text{wid}(m, 0) = \text{Vréf} - \text{Nmax} \qquad (10b)$$

En considérant l'image originale de la figure 10 de taille 5x5 et en prenant comme valeur de référence Vréf la valeur hexadécimale FFFF, correspondant à un registre de 16 bits, ces relations deviennent :

$$\forall n \in [1, 5], \text{wid}(0, n) = \text{FFFF} - [(5 - 1) + (5 - 1)] = \text{FFF7}$$

$$\forall m \in [1, 5], \text{wid}(m, 0) = \text{FFFF} - 8 = \text{FFF7}$$

Toujours dans l'étape d'initialisation 101, l'indice de ligne m et l'indice de colonne n sont initialisés à la valeur '1'. Dans une deuxième sous-étape 102, on vérifie si le pixel central p(m,n) appartient à l'objet, par exemple en vérifiant que son poids wo(m,n) dans l'image originale est égal à la valeur '1'. Si tel est le cas, le poids wid(m,n) de ce pixel dans l'image intermédiaire est fixé à zéro dans une sous-étape 103 afin d'indiquer une distance nulle entre ce pixel et l'objet. Dans le cas contraire, le poids wid(m,n) du pixel central p(m,n) de l'image intermédiaire est fixé, dans une sous-étape 104, à la valeur minimale des poids $V_1$ et $B_1$ incrémentés d'une unité, conformément à la relation 8. A l'issue de la sous-étape 103 ou de la sous-étape 104, on regarde, dans une sous-étape 105, si l'élément structurant est arrivé en bout de ligne. Cette condition est par exemple vérifiée lorsque l'indice n de colonne est égale au nombre N de colonnes. Si cette condition n'est pas vérifiée, l'indice n de colonne est incrémenté d'une unité dans une sixième sous-étape 106. A la fin de cette sous-étape 106, une nouvelle itération est exécutée à partir de la deuxième sous-étape 102 afin de déterminer le poids wid(m,n+1) du pixel suivant p(m,n+1) de la ligne. En revanche, si l'élément structurant est arrivé en bout de ligne, on regarde, dans une sous-étape 107, si l'élément structurant est également arrivé en bout de colonne, autrement dit si le pixel central p(m,n) correspond au dernier pixel p(M,N) de l'image. Si cette condition est vérifiée, il est mis fin à la première étape dans une sous-étape 108, l'image intermédiaire étant complètement déterminée. L'image intermédiaire ainsi obtenue est illustrée à la figure 10 (exemple avec un compteur à 16 bits). Si la condition de la sous-étape 107 n'est pas vérifiée, l'indice m de ligne est incrémenté d'une unité et l'indice n de colonne est réinitialisé à la valeur '1' dans une sous-étape 109. A l'issue de cette sous-étape 109, une nouvelle itération est exécutée à partir de la deuxième sous-étape 102.

La figure 11 illustre des sous-étapes de la seconde étape. Cette seconde étape est par exemple exécutée à la suite de la sous-étape 108. Dans une première sous-étape, appelée étape d'initialisation 201, une ligne d'initialisation (m=M+1) et une colonne d'initialisation (n=N+1) sont insérées, respectivement, après la dernière ligne (m=M) et après la dernière colonne (n=N) de l'image distance. Les poids wd(M+1,n) et wd(m,N+1) des pixels p(M+1,n) et p(m,N+1) de la ligne d'initialisation (m=M+1) et de la colonne d'initialisation (n=N+1) sont fixés en fonction de la valeur de référence Vréf fixée lors de la première étape, conformément aux relations :

$$\forall n \in [1, N], \text{wd}(M + 1, n) = \text{Vréf} - 1 \qquad (11a)$$

$$\forall m \in [1, M], \text{wd}(m, N + 1) = \text{Vréf} - 1 \qquad (11b)$$

En considérant l'image intermédiaire de la figure 10, reproduite à la figure 12, ces relations deviennent :

$$\forall n \in [1, 5], \text{wd}(M + 1, n) = \text{FFFF} - 1 = \text{FFFE}$$

$$\forall m \in [1,5], \, wd(m, N+1) = FFFF - 1 = FFFE$$

Toujours dans l'étape d'initialisation 201, l'indice de ligne m est initialisé à la valeur 'M' et l'indice de colonne n est initialisé à la valeur 'N'. Dans une deuxième sous-étape 202, le poids wd(m,n) du pixel central p(m,n) de l'image distance est fixé à la valeur minimale des poids r, $B_2$+1 et $V_2$+1, conformément à la relation 9. A l'issue de la sous-étape 202, on regarde, dans une sous-étape 203, si l'élément structurant est arrivé en bout de ligne. Cette condition est par exemple vérifiée lorsque l'indice n de colonne est égal à la valeur '1'. Si cette condition n'est pas vérifiée, l'indice n de colonne est décrémenté d'une unité dans une sous-étape 204. A la fin de cette sous-étape 204, une nouvelle itération est exécutée à partir de la deuxième sous-étape 202 afin de déterminer le poids wd(m,n-1) du pixel suivant p(m,n-1) de la ligne. En revanche, si l'élément structurant est arrivé en bout de ligne, on regarde, dans une sous-étape 205, si l'élément structurant est également arrivé en bout de colonne, autrement dit si le pixel central p(m,n) correspond au premier pixel p(1,1) de l'image. Si cette condition est vérifiée, il est mis fin à la seconde étape dans une sous-étape 206, l'image distance étant complètement déterminée. L'image distance ainsi obtenue est illustrée à la figure 12. Si la condition de la sous-étape 205 n'est pas vérifiée, l'indice m de ligne est décrémenté d'une unité et l'indice n de colonne est réinitialisé à la valeur 'N' dans une sous-étape 207. A l'issue de cette sous-étape 207, une nouvelle itération est exécutée à partir de la deuxième sous-étape 202.

*Projection*

La figure 13 illustre l'opération de projection. Cette opération permet de déterminer une nouvelle ligne (m=X) et une nouvelle colonne (n=Y) à partir d'une image originale, les poids wp(X,n) des pixels p(X,n) de la nouvelle ligne étant respectivement égaux à la somme des poids wo(m,n) de tous les pixels p(m,n) de la colonne correspondante de l'image originale, et les poids wp(m,Y) des pixels p(m,Y) de la nouvelle colonne étant respectivement égaux à la somme des poids wo(m,n) de tous les pixels p(m,n) de la ligne correspondante de l'image originale. Les poids wp(X,n) et wp(m,Y) des pixels p(X,n) et p(m,Y) de la nouvelle ligne et de la nouvelle colonne peuvent être modélisés par les relations :

$$\forall n \in [1, N], \, wp(X, n) = \sum_{x=1}^{M} wo(x, n) \qquad (12a)$$

$$\forall m \in [1, M], \, wp(m, Y) = \sum_{y=1}^{N} wo(m, y) \qquad (12b)$$

**Description du module reconfigurable**

*Bloc opérateur*

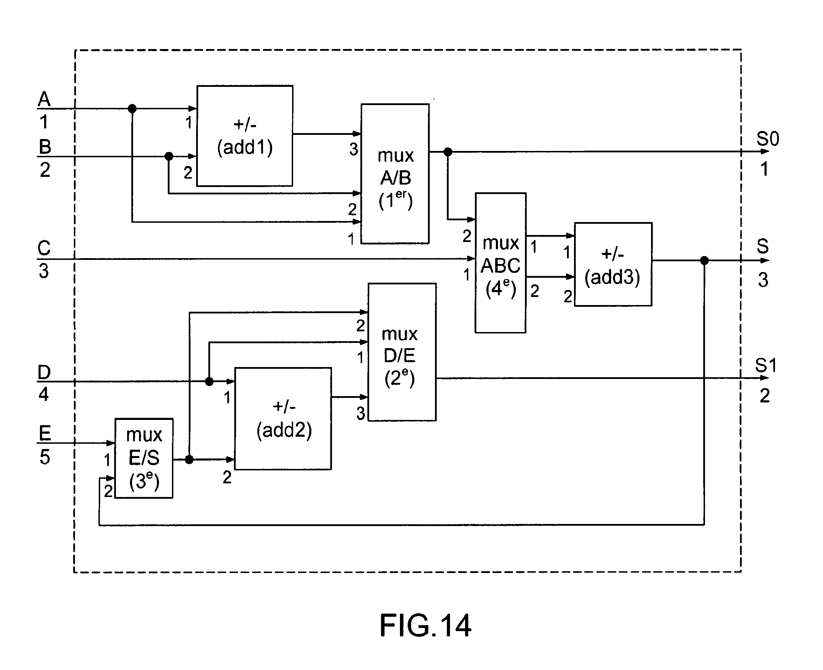

La figure 14 représente schématiquement un bloc opérateur d'un module reconfigurable selon l'invention. Le bloc opérateur comporte cinq entrées, repérées par les lettres A, B, C, D et E, et trois sorties, repérées S0, S1 et S. Ces entrées/sorties permettent notamment de réaliser les opérations définies ci-dessus. Elles permettent également de réaliser des variantes de ces opérations ainsi que d'autres fonctions non décrites ici. Le bloc opérateur comporte également trois additionneurs/soustracteurs et quatre blocs logiques dont l'agencement permet de délivrer sur chaque sortie S0, S1 et S un résultat d'une opération effectuée sur les entrées A, B, C, D et/ou E, le résultat dépendant du type d'opération effectué par les additionneurs/soustracteurs et des liaisons établies entre les entrées et les sorties des différents blocs logiques. Par souci de concision, les entrées A, B, C, D et E, les sorties S0, S1 et S, ainsi que les entrées/sorties des additionneurs/soustracteurs et des blocs logiques, sont confondues avec les données présentes sur ces entrées et ces sorties. Par bloc logique, on entend un circuit commandé possédant une ou plusieurs entrées et une ou plusieurs sorties, chaque sortie pouvant être en liaison avec l'une des entrées en fonction d'une commande appliquée au bloc logique, par exemple par un contrôleur général ou par une logique interne au bloc logique. Le terme bloc logique est entendu au sens large. Bien entendu, un bloc logique possédant plusieurs entrées et/ou sorties peut être réalisé par un ensemble de multiplexeurs et de portes logiques possédant chacun une ou plusieurs entrées et une ou plusieurs sorties.

Selon l'invention, la première sortie S0 du bloc opérateur peut délivrer soit le résultat de l'addition (A+B) de la première entrée A et de la deuxième entrée B du bloc opérateur, soit le résultat de la soustraction (A-B) de la deuxième entrée B à la première entrée A du bloc opérateur, soit le minimum (min(A, B)) de la première entrée A et de la deuxième entrée B du bloc opérateur, soit le maximum (max(A, B)) de la première entrée A et de la deuxième entrée B du bloc opérateur. La deuxième sortie S1 du bloc opérateur peut délivrer soit le résultat de l'addition (D+E) de la quatrième entrée D et de la cinquième entrée E du bloc opérateur, soit le résultat de la soustraction (D-E) de la cinquième entrée E à la quatrième entrée D du bloc opérateur, soit le minimum (min(D, E)) de la quatrième entrée D et de la cinquième entrée E du bloc opérateur, soit le maximum (max(D, E)) de la quatrième entrée D et de la cinquième entrée E du bloc opérateur, soit le minimum (min(A, B, D)) de la première entrée A, de la deuxième entrée B et de la quatrième entrée D du bloc opérateur, soit le maximum (max(A, B, D)) de la première entrée A, de la deuxième entrée B et de la quatrième entrée D du bloc opérateur. La troisième sortie S du bloc opérateur peut délivrer soit le résultat de l'addition (S0+C) de la première sortie S0 et de la troisième entrée C du bloc opérateur, soit le résultat de la soustraction (S0-C) de la troisième entrée C à la première sortie S0.

Les différentes combinaisons de résultats sur les trois sorties S0, S1 et S du bloc opérateur permettent de réaliser les cinq opérations morphologiques décrites précédemment avec un minimum de composants présents dans le module reconfigurable. Par conséquent, il est possible d'économiser de la surface silicium, et donc de diminuer l'encombrement et le coût du module reconfigurable. En outre, à chaque coup d'horloge, un résultat peut être fourni, le module reconfigurable selon l'invention correspondant à une architecture dite pipeline. Le résultat peut être le poids d'un pixel d'une image intermédiaire ou le poids d'un pixel d'une image intégrale, d'une image érodée, d'une image dilatée ou d'une image distance. Les opérations morphologiques peuvent ainsi être réalisées très rapidement.

Les résultats pouvant être obtenus sur les sorties S0, S1 et S du bloc opérateur résultent par exemple de l'agencement des additionneurs/ soustracteurs et des blocs logiques décrit ci-après. Selon cet agencement, la première entrée A et la deuxième entrée B du bloc opérateur sont respectivement reliées à une première et à une seconde entrée d'un premier additionneur/soustracteur add1 et à une première et à une deuxième entrée d'un premier bloc logique mux A/B. Une sortie du premier additionneur/ soustracteur add 1 est reliée à une troisième entrée du premier bloc logique mux A/B. Une sortie de ce premier bloc logique mux A/B forme la première sortie S0 du bloc opérateur. Toujours selon cet agencement, la quatrième entrée D du bloc opérateur est reliée à une première entrée d'un deuxième additionneur/ soustracteur add 2 et à une première entrée d'un deuxième bloc logique mux D/E. La cinquième entrée E du bloc opérateur est reliée à une première entrée d'un troisième bloc logique mux E/S. Une sortie de ce troisième bloc logique mux E/S est reliée à une seconde entrée d'un deuxième additionneur/soustracteur add 2 et à une deuxième entrée du deuxième bloc logique mux D/E. Une sortie du deuxième additionneur/soustracteur add 2 est reliée à une troisième entrée du deuxième bloc logique mux D/E. Une sortie du deuxième bloc logique mux D/E forme la deuxième sortie S1 du bloc opérateur. Toujours selon cet agencement, la troisième entrée C du bloc opérateur et la sortie du premier bloc logique mux A/B sont respectivement reliées à une première et à une deuxième entrée d'un quatrième bloc logique mux ABC. Une première et une seconde sortie de ce quatrième bloc logique mux ABC sont respectivement reliées à une première et à une seconde entrée d'un troisième additionneur/soustracteur add 3. Une sortie du troisième additionneur/ soustracteur add 3 est reliée à une seconde entrée du troisième bloc logique mux E/S et forme la troisième sortie S du bloc opérateur.

Selon une forme particulière de réalisation, la première sortie S0 du bloc opérateur délivre le minimum (min (A, B)) ou le maximum (max(A, B)) des première et deuxième entrées A et B du bloc opérateur en effectuant une soustraction (A-B) de la deuxième entrée B à la première entrée A du bloc opérateur et en étudiant le signe du résultat de la soustraction (A-B). Le signe du résultat de la soustraction est par exemple donné par le bit de signe du premier additionneur/soustracteur add 1. Pour le minimum (min(A, B)), si le résultat de la soustraction (A-B) est négatif, une liaison est établie entre la première entrée et la sortie du premier bloc logique mux A/B, et si le résultat de la soustraction (A-B) est positif, une liaison est établie entre la deuxième entrée et la sortie du premier bloc logique mux A/B. Pour le maximum (max(A, B)), si le résultat de la soustraction (A-B) est positif, une liaison est établie entre la première entrée et la sortie du premier bloc logique mux A/B, et si le résultat de la soustraction (A-B) est négatif, une liaison est établie entre la deuxième entrée et la sortie du premier bloc logique mux A/B. Le même principe peut être appliqué au deuxième additionneur/soustracteur add 2 et au deuxième bloc logique mux D/E afin de déterminer le minimum (min(D, E)) ou le maximum (max(D, E)) des quatrième et cinquième entrées D et E du bloc opérateur. Le signe du résultat de la soustraction (D-E) de la cinquième entrée E à la quatrième entrée D du bloc opérateur détermine la liaison devant être établie entre la sortie et la première ou la deuxième entrée du deuxième bloc logique mux D/E.

### Module reconfigurable

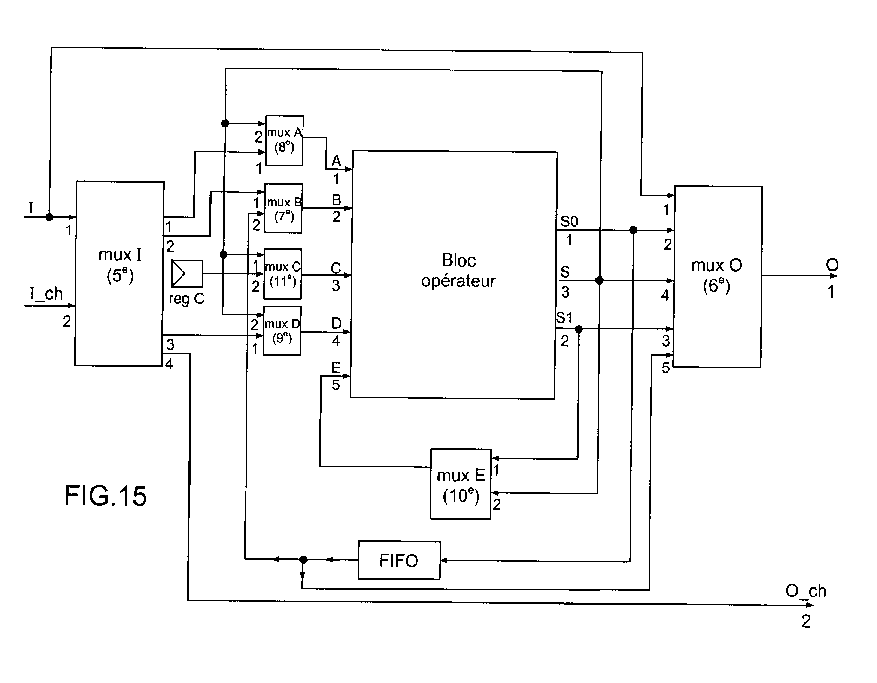

Selon une forme particulière de réalisation, représentée à la figure 15, le module reconfigurable comporte une première entrée I, une seconde entrée I_ch, une première sortie O, une deuxième sortie O_ch, un cinquième bloc logique mux I permettant de gérer le flux de données entrant sur le bloc opérateur et un sixième bloc logique mux O permettant de gérer le flux de données sortant du bloc opérateur. En particulier, la première entrée I du module reconfigurable peut être reliée à une première entrée du cinquième bloc logique mux I et à une première entrée du sixième bloc logique mux O. La deuxième entrée I_ch peut être reliée à une deuxième entrée du cinquième bloc logique mux I. Une première, une deuxième et une troisième sortie du cinquième bloc logique mux I peuvent être respectivement reliées à la première, à la deuxième et à la quatrième entrée A, B, D du bloc opérateur. Les première, deuxième et troisième sorties S0 S1, S du bloc opérateur peuvent être respectivement reliées à une deuxième, à une troisième et à une quatrième entrée du sixième bloc logique mux O. Une sortie du bloc logique mux O forme la première sortie O du module reconfigurable et une quatrième sortie du bloc logique mux I forme la seconde sortie O_ch du module reconfigurable. Cette seconde sortie O_ch est apte à être reliée à l'entrée I_ch d'un deuxième module reconfigurable dans le cadre d'un montage en cascade. Autrement dit, le module reconfigurable selon l'invention peut être chaîné afin de réaliser des opérations morphologiques plus complexes, telles que des opérations d'érosion ou de dilatation par des éléments structurants de dimension supérieures à 3x3.

Selon une forme particulière de réalisation, représentée à la figure 15, le module reconfigurable comporte une pile FIFO permettant de stocker temporairement des données et un septième bloc logique mux B permettant de gérer le flux de données entrant sur la deuxième entrée B du bloc opérateur. Par pile FIFO, on entend une pile dont la première donnée entrante est la première sortie. La deuxième sortie du cinquième bloc logique mux I peut être reliée à une première entrée du bloc logique mux B. Une sortie de ce bloc logique mux B peut être reliée à la deuxième entrée B du bloc opérateur. La première sortie S0 du bloc opérateur peut être reliée à une entrée de la pile FIFO, une sortie de la pile FIFO pouvant être reliée à une deuxième entrée du septième bloc logique mux B et à une cinquième entrée du sixième bloc logique mux O.

Selon une forme particulière de réalisation, représentée à la figure 15, le module reconfigurable comporte des moyens pour réinjecter les données présentes sur les sorties S1 et S du bloc opérateur en entrée du bloc opérateur. En particulier, ces moyens peuvent comporter un huitième bloc logique mux A, un neuvième bloc logique mux D et un dixième bloc logique mux E. Les première et troisième sorties du cinquième bloc logique mux I peuvent être respectivement reliées à une première entrée du huitième bloc logique mux A et à une première entrée du neuvième bloc logique mux D. La troisième sortie S du bloc opérateur peut être reliée à une deuxième entrée du huitième bloc logique mux A, à une deuxième entrée du neuvième bloc logique mux D et à la troisième entrée C du bloc opérateur. Les deuxième et troisième sorties S1, S du bloc opérateur peuvent être respectivement reliées à une première et à une deuxième entrée du dixième bloc logique mux E, une sortie de ce bloc logique mux E pouvant être reliée à la cinquième entrée E du bloc opérateur.

Selon une forme particulière de réalisation, représentée à la figure 15, le module reconfigurable comprend un registre de données reg C et un onzième bloc logique mux C. La troisième sortie S du bloc opérateur et le registre de données reg C peuvent être respectivement reliés à une première et à une deuxième entrée du bloc logique mux C. Une sortie de ce bloc logique mux C peut être reliée à la troisième entrée C du bloc opérateur. Cette forme particulière de réalisation permet de réaliser des opérations avec des données de valeur prédéterminée, par exemple "zéro" et "un".

## Description du procédé de mise en oeuvre du module reconfigurable

Le module reconfigurable décrit ci-dessus peut être mis en oeuvre afin de réaliser les opérations morphologiques également décrites ci-dessus. En particulier, le module reconfigurable peut déterminer, à partir d'une image originale comprenant M lignes et N colonnes de pixels p(m,n), soit une image intégrale, soit une image érodée, soit une image dilatée, soit une image distance de Manhattan, soit une projection suivant les lignes et les colonnes de l'image originale, et ce, en fonction du type d'opération effectué par les additionneurs/soustracteurs add 1 à add 3 et des liaisons établies entre les entrées et les sorties des différents blocs logiques.

### Intégration

Selon une forme particulière de réalisation, la détermination de l'image intégrale comporte les étapes suivantes :

- définir une image intermédiaire de même dimension que l'image originale, à chaque pixel p(m,n) de l'image intermédiaire étant associé un poids wii(m,n),
- initialiser les poids wii(1,n) des pixels p(1,n) de la première ligne (m=1) de l'image intermédiaire,
- réitérer les étapes suivantes pour n variant de 2 à N :

  ◦ réitérer les étapes suivantes pour m variant de 2 à M :

    ■ additionner le poids wo(m,n) des pixels p(m,n) de l'image originale avec le poids wii(m-1,n) des pixels p(m-1,n) de l'image intermédiaire,
    ■ stocker les résultats des additions dans la pile FIFO, la pile FIFO étant de taille M-1,

- initialiser les poids wi(m,1) des pixels p(m,1) de la première colonne (n=1) de l'image intégrale,
- réitérer les étapes suivantes pour m variant de 2 à M :

  ◦ réitérer les étapes suivantes pour n variant de 2 à N :

  ■ additionner le poids wii(m,n) des pixels p(m,n) de l'image intermédiaire avec le poids wi(m,n-1) des pixels p(m,n-1) de l'image intégrale.

Ces étapes sont particulièrement adaptées au module reconfigurable selon l'invention. En particulier, l'étape d'addition du poids wo(m,n) des pixels p(m,n) de l'image originale avec le poids wii(m-1,n) des pixels p(m-1,n) de l'image intermédiaire peut être réalisée de la manière suivante. Les poids wo(m,n) sont injectés sur la première entrée I du module reconfigurable ; les cinquième et huitième blocs logiques mux I, mux A relient la première entrée I du module reconfigurable à la première entrée A du bloc opérateur ; le septième bloc logique mux B relie la sortie de la pile FIFO à la deuxième entrée B du bloc opérateur. Ainsi, le bloc opérateur peut réaliser l'addition des poids wo(m,n) et wii(m-1,n). Le sixième bloc logique mux O relie la sortie S0 du bloc opérateur à la sortie O du module reconfigurable afin de fournir sur cette sortie O, à chaque coup d'horloge, un poids wii(m,n) d'un pixel p(m,n) de l'image intermédiaire.

Par ailleurs, l'étape d'addition du poids wii(m,n) des pixels p(m,n) de l'image intermédiaire avec le poids wi(m, n-1) des pixels p(m,n-1) de l'image intégrale peut être réalisée de la manière suivante. Les poids wii(m,n) sont injectés sur la première entrée I du module reconfigurable ; les cinquième et huitième blocs logiques mux I, mux A relient la première entrée I du module reconfigurable à la première entrée A du bloc opérateur. Le septième bloc logique mux B relie la sortie de la pile FIFO à la deuxième entrée B du bloc opérateur. Ainsi, le bloc opérateur peut réaliser l'addition des poids wii(m,n) et wi(m,n-1), ces derniers provenant de la pile FIFO. Le sixième bloc logique mux O relie la sortie S0 du bloc opérateur à la sortie O du module reconfigurable afin de fournir sur cette sortie O, à chaque coup d'horloge, un poids wi(m,n) d'un pixel p(m,n) de l'image intégrale.

Les étapes précédentes nécessaires au calcul de l'image intégrale sont réalisées dans le bloc opérateur en additionnant la première entrée A et la deuxième entrée B du bloc opérateur avec l'additionneur add 1. Le résultat est routé sur la sortie S0 via le premier bloc logique mux A/B.

L'étape d'initialisation des poids wii(1,n) des pixels p(1,n) de la première ligne (m=1) de l'image intermédiaire peut être réalisée en fixant ces poids wii(1,n) aux mêmes valeurs que les poids wo(1,n) des pixels p(1,n) de la première ligne (m=1) de l'image originale. De même, l'étape d'initialisation des poids wi(m,1) des pixels p(m,1) de la première colonne (n=1) de l'image intégrale peut être réalisée en fixant ces poids wi(m,1) aux mêmes valeurs que les poids wii(m,1) des pixels p(m,1) de la première colonne (n=1) de l'image intermédiaire.

*Erosion - dilatation*

Selon une forme particulière de réalisation, la détermination de l'image érodée par un élément structurant de dimension 3x3 comporte les étapes suivantes :

- décomposer l'élément structurant en un premier sous-élément structurant de dimension 1x3 et en un second sous-élément structurant de dimension 3x1,
- définir une image intermédiaire de même dimension que l'image originale, à chaque pixel p(m,n) de l'image intermédiaire étant associé un poids wie(m,n),
- réitérer les étapes suivantes pour m variant de 1 à M :

  ◦ réitérer les étapes suivantes pour n variant de 1 à N :

  ■ attribuer au poids wie(m,n) le minimum des poids wo(x,y) des pixels p(x,y) appartenant au premier sous-élément structurant centré sur le pixel p(m,n) considéré,

- réitérer les étapes suivantes pour n variant de 1 à N :

  ◦ réitérer les étapes suivantes pour m variant de 1 à M :

  ■ attribuer au poids we(m,n) le minimum des poids wie(x,y) des pixels p(x,y) appartenant au second sous-élément structurant centré sur le pixel p(m,n) considéré.

Ces étapes peuvent être obtenues par le module reconfigurable en injectant les poids wo(x,y) ou wie(x,y) sur la première entrée I du module reconfigurable, le cinquième bloc logique mux I reliant successivement la première entrée

I du module reconfigurable à la première entrée A du bloc opérateur via le huitième bloc logique mux A, à la deuxième entrée B du bloc opérateur via le septième bloc logique mux B et à la quatrième entrée D du bloc opérateur via le neuvième bloc logique mux D. Le dixième bloc logique mux E relie la troisième sortie S à la cinquième entrée E du bloc opérateur. Le bloc opérateur peut ainsi déterminer le minimum des poids wo(x,y) ou wie(x,y) des pixels p(x,y) appartenant au premier ou au second sous-élément structurant centré sur le pixel p(m,n). Le sixième bloc logique mux O relie la deuxième sortie S1 du bloc opérateur à la première sortie O du module reconfigurable afin de fournir sur cette sortie O, à chaque coup d'horloge, soit le poids wie(m,n) des pixels p(m,n) de l'image intermédiaire, soit le poids we(m,n) des pixels p(m,n) de l'image érodée.

L'attribution aux poids wie(m,n) et we(m,n), respectivement du minimum des poids wo(x,y) des pixels p(x,y) appartenant au premier sous-élément structurant et du minimum des poids wie(x,y) des pixels p(x,y) appartenant au second sous-élément structurant peut comprendre les étapes suivantes :

- soustraire la deuxième entrée (B) à la première entrée (A) du premier additionneur/soustracteur add 1,
- établir une liaison entre la première entrée (A) ou la deuxième entrée (B) et la sortie du premier bloc logique mux A/B en fonction du signe du résultat de la soustraction (A-B),
- établir une liaison entre la deuxième entrée et la première sortie du quatrième bloc logique mux ABC,
- additionner ou soustraire la première entrée du troisième additionneur/soustracteur add 3 avec la valeur nulle,
- établir une liaison entre la première entrée et la sortie du troisième bloc logique mux E/S,
- soustraire la deuxième entrée (E=S=A ou E=S=B) à la première entrée (D) du deuxième additionneur/soustracteur add 2,
- établir une liaison entre la première ou la deuxième entrée (D, E=S=A ou E=S=B) et la sortie du deuxième bloc logique mux D/E en fonction du signe du résultat de la deuxième soustraction (D-E).

Les étapes permettant de déterminer l'image dilatée par un élément structurant de dimension 3x3 peuvent être facilement déduites des étapes précédentes relatives à la détermination de l'image érodée, les opérations de minimum étant simplement remplacées par des opérations de maximum.

Le module reconfigurable selon l'invention permet également de déterminer rapidement une image érodée ou une image dilatée par un élément structurant de dimension supérieure à 3x3, par exemple 5x5. En particulier, pour une érosion par un élément structurant de dimension 5x5, il faut faire la comparaison de 5 valeurs et garder le minimum de ces 5 valeurs. L'idée est de poursuivre le mode de pipeline réalisé par un module reconfigurable pour une érosion 3x3 en utilisant deux modules reconfigurables et en répartissant les 5 valeurs sur les deux modules afin de pouvoir les comparer.

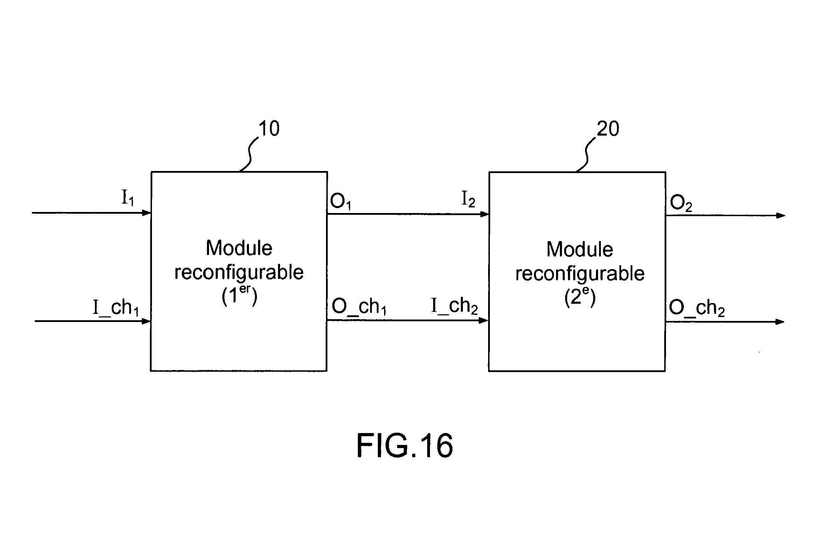

La figure 16 illustre un exemple d'agencement de deux modules reconfigurables chaînés permettant d'obtenir une image érodée par un élément structurant de dimension 5x5. La première sortie $O_1$ d'un premier module reconfigurable 10 est reliée à la première entrée $I_2$ d'un deuxième module reconfigurable 20 et la deuxième sortie $O\_ch_1$ du premier module reconfigurable 10 est reliée à la deuxième sortie $O\_ch_2$ du deuxième module reconfigurable 20. Les poids wo(x,y) ou wie(x,y) sont alors injectés sur la première entrée $I_1$ du premier module reconfigurable 10, la deuxième entrée $I\_ch_1$ du premier module reconfigurable 10 n'étant pas utilisée. Le minimum des poids wo(x,y) de trois pixels p(x,y) appartenant au premier sous-élément structurant ou le minimum des poids wie(x,y) de trois pixels appartenant au second sous-élément structurant peut alors être obtenu sur la première sortie $O_1$ du premier module reconfigurable 10, les poids wo(x,y) ou wie(x,y) des deux autres pixels p(x,y) appartenant au sous-élément structurant considéré étant simplement transférés au deuxième module reconfigurable 20 via la sortie $O\_ch_1$ et la deuxième entrée $I\_ch_2$. Le minimum des poids wo(x,y) ou wie(x,y) des cinq pixels p(x,y) appartenant au sous-élément structurant considéré pouvant alors être obtenu sur la première sortie $O_2$ du deuxième module reconfigurable 20.

Bien entendu, le chaînage décrit ci-dessus permet également d'obtenir des images dilatées par un élément structurant de dimension 5x5. En outre, le module reconfigurable selon l'invention est particulièrement adapté au chaînage de deux modules reconfigurables ou plus. Un tel chaînage permet d'utiliser des éléments structurants de plus grande dimension. Par exemple, un chaînage de trois modules reconfigurables permet d'utiliser des éléments structurants de dimension 7x7.

### Distance

Selon une forme particulière de réalisation, la détermination de l'image distance comporte les étapes suivantes :

- définir une image intermédiaire de même dimension que l'image originale, à chaque pixel p(m,n) de l'image intermédiaire étant associé un poids wid(m,n),
- définir un premier élément structurant composé de trois pixels, un pixel central p(m,n), un pixel p(m,n-1) situé sur la même ligne que le pixel central p(m,n) à la colonne précédente et un pixel p(m-1 ,n) situé sur la même colonne que le pixel central $p(m,n)$ à la ligne précédente,

- réitérer les étapes suivantes pour m variant de 1 à M :

  ○ réitérer les étapes suivantes pour n variant de 1 à N :

  ■ déterminer si le pixel central $p(m,n)$ appartient à l'objet,

  • si tel est le cas, attribuer au poids $wid(m,n)$ la valeur nulle, le sixième bloc logique mux O reliant la première entrée I du module reconfigurable à la première sortie O du module reconfigurable,
  • si tel n'est pas le cas, attribuer au poids $wid(m,n)$ le minimum des poids $wid(m,n-1)=V_1$ et $wid(m-1,n)=B_1$ incrémentés d'une unité, le sixième bloc logique mux O reliant la troisième sortie S du bloc opérateur à la première sortie O du module reconfigurable,

- définir un second élément structurant composé de trois pixels, un pixel central $p(m,n)$, un pixel $p(m+1,n)$ situé sur la même colonne que le pixel central $p(m,n)$ à la ligne suivante et un pixel $p(m,n+1)$ situé sur la même ligne que le pixel central à la colonne suivante,
- réitérer les étapes suivantes pour m variant de M à 1 :

  ○ réitérer les étapes suivantes pour n variant de N à 1 :

  ■ attribuer au poids $wd(m,n)$ du pixel central $p(m,n)$ le minimum des poids $wid(m,n)=r$, $wd(m+1,n)+1=B_2+1$ et $wd(m,n+1)+1=V_2+1$.

Les étapes pour m variant de 1 à M et pour n variant de 1 à N peuvent être obtenues par le module reconfigurable, notamment lorsque le septième bloc logique mux B relie la sortie de la pile FIFO à la deuxième entrée B du bloc opérateur et le huitième bloc logique mux A relie la troisième sortie S du bloc opérateur à la première entrée A du bloc opérateur.

Les étapes pour m variant de M à 1 et pour n variant de N à 1 peuvent être obtenues par le module reconfigurable, notamment lorsque les cinquième et neuvième blocs logiques mux I, mux D relient la première entrée I du module reconfigurable à la quatrième entrée D du bloc opérateur, le sixième bloc logique mux O relie la deuxième sortie S1 du bloc opérateur à la première sortie O du module reconfigurable, le septième bloc logique mux B relie la sortie de la pile FIFO à la deuxième entrée B du bloc opérateur et le huitième bloc logique mux A relie la troisième sortie S du bloc opérateur à la première entrée A du bloc opérateur.

L'attribution au poids $wid(m,n)$ du minimum des poids $V_1$ et $B_1$ incrémentés d'une unité peut comprendre les étapes suivantes :

- soustraire la deuxième entrée B, recevant le poids $B_1$, à la première entrée A, recevant le poids $V_1$, du premier additionneur/soustracteur add 1,
- établir une liaison entre la première entrée, recevant le poids $V_1$, ou la deuxième entrée, recevant le poids $B_1$, et la sortie du premier bloc logique mux A/B en fonction du signe du résultat de la soustraction $(V_1-B_1)$,
- établir une liaison entre la deuxième entrée, recevant le poids $B_1$ ou $V_1$, et la première sortie et entre la première entrée, reliée à l'entrée C, et la deuxième sortie du quatrième bloc logique mux ABC,
- additionner la première entrée du troisième additionneur/soustracteur add 3 avec la valeur "un", le onzième bloc logique mux C reliant le registre de données reg C à la troisième entrée C du bloc opérateur.

Par ailleurs, l'attribution au poids $wd(m,n)$ du minimum des poids r, $B_2+1$ et $V_2+1$ peut comprendre les étapes suivantes :

- soustraire la deuxième entrée, recevant le poids $B_2$, à la première entrée, recevant le poids $V_2$, du premier additionneur/soustracteur add 1,
- établir une liaison entre la première entrée, recevant le poids $V_2$, ou la deuxième entrée, recevant le poids $B_2$, et la sortie du premier bloc logique mux A/B en fonction du signe du résultat de la soustraction $(V_2-B_2)$,
- établir une liaison entre la deuxième entrée, recevant le poids $B_2$ ou $V_2$, et la première sortie et entre la première entrée, reliée à l'entrée C, et la deuxième sortie du quatrième bloc logique mux ABC,
- additionner la première entrée du troisième additionneur/soustracteur add 3 avec la valeur "un", le onzième bloc logique mux C reliant le registre de données reg C à la troisième entrée C du bloc opérateur,
- établir une liaison entre la sortie du troisième additionneur/ soustracteur add 3 et la deuxième entrée du deuxième additionneur/ soustracteur add 2 via le troisième bloc logique mux E/S,
- soustraire la deuxième entrée, recevant le poids $B_2+1$ ou $V_2+1$, à la première entrée, recevant le poids r, du deuxième additionneur/soustracteur add 2,

- établir une liaison entre la première entrée, recevant le poids r, ou la deuxième entrée, recevant le poids $B_2+1$ ou $V_2+1$, et la sortie du deuxième bloc logique mux D/E en fonction du signe du résultat de la soustraction ($r-(B_2+1)$ ou $r-(V_2+1)$).

### Projection

Selon une forme particulière de réalisation, la détermination de la nouvelle ligne (m=X) et de la nouvelle colonne (n=Y) de l'opération de projection, appelées respectivement ligne de projection et colonne de projection, comporte les étapes suivantes :

- définir une ligne de projection comportant le même nombre N de colonnes que les lignes de l'image originale et une colonne de projection comportant le même nombre M de lignes que les colonnes de l'image originale, à chaque pixel p(X,n) de la ligne de projection et à chaque pixel p(m,Y) de la colonne de projection étant associé respectivement un poids wp(X,n) et wp(m,Y),
- réitérer les étapes suivantes pour m variant de 1 à M :

  ○ réitérer les étapes suivantes pour n variant de 1 à N :

    ■ additionner le poids wp(m,Y) des pixels p(m,Y) de la colonne de projection avec le poids wo(m,n) des pixels p(m,n) de l'image originale,
    ■ additionner le poids wp(X,n) des pixels p(X,n) de la ligne de projection avec le poids wo(m,n) des pixels p(m,n) de l'image originale.

L'étape d'addition du poids wp(m,Y) avec le poids wo(m,n) peut être obtenue par le module reconfigurable en injectant les poids wo(m,n) sur la première entrée I du module reconfigurable. Le cinquième bloc logique mux I peut relier la première entrée I du module reconfigurable à la quatrième entrée D du bloc opérateur via le neuvième bloc logique mux D. Le dixième bloc logique mux E peut relier la deuxième sortie S1 à la cinquième entrée E du bloc opérateur. Le bloc opérateur peut alors calculer la somme des poids wo(m,n) des pixels p(m,n) d'une ligne (m) à l'aide du deuxième additionneur/ soustracteur add 2, le troisième bloc logique mux E/S reliant la cinquième entrée E du bloc opérateur à la seconde entrée du deuxième additionneur/ soustracteur add 2 et le deuxième bloc logique mux D/E reliant la sortie de cet additionneur/soustracteur add 2 à la deuxième sortie S1 du bloc opérateur. Lorsque n atteint le nombre N de colonnes de l'image originale, le sixième bloc logique mux O peut relier la deuxième sortie S1 à la première sortie O du module reconfigurable pour permettre l'évacuation du résultat de la somme d'une ligne (m).

L'étape d'addition du poids wp(X,n) avec le poids wo(m,n) peut être obtenue par le module reconfigurable en injectant les poids wo(m,n) sur la première entrée I du module reconfigurable. Le cinquième bloc logique mux I peut relier la première entrée I du module reconfigurable à la première entrée A du bloc opérateur via le huitième bloc logique mux A. Le septième bloc logique mux B peut relier la sortie de la pile FIFO à la deuxième entrée B du bloc opérateur. Le bloc opérateur peut alors calculer la somme des poids wo(m,n) des pixels p(m,n) d'une colonne (n) à l'aide du premier additionneur/soustracteur add 1, les résultats des additions des poids wp(X,n) et wo(m,n) étant stockés dans la pile FIFO et le premier bloc logique mux A/B reliant la sortie du premier additionneur/soustracteur add 1 à la première sortie S0 du bloc opérateur. Lorsque m atteint le nombre M de lignes de l'image originale, la pile FIFO contient les résultats des sommes des colonnes. La pile FIFO peut alors être vidée par l'intermédiaire du sixième bloc logique mux O, ce dernier reliant la sortie de la pile FIFO à la première sortie O du module reconfigurable.

### Revendications

1. Module reconfigurable, **caractérisé en ce qu'**il comporte un bloc opérateur comprenant cinq entrées (A, B, C, D, E) et trois sorties (S0, S1, S),
la première sortie (S0) du bloc opérateur étant apte à délivrer soit le résultat de l'addition (A+B) de la première et de la deuxième entrée (A, B) du bloc opérateur, soit le résultat de la soustraction (A-B) de la deuxième entrée (B) à la première entrée (A) du bloc opérateur, soit le minimum (min(A, B)) de la première et de la deuxième entrée (A, B) du bloc opérateur, soit le maximum (max(A, B)) de la première et de la deuxième entrée (A, B) du bloc opérateur,
la deuxième sortie (S1) du bloc opérateur étant apte à délivrer soit le résultat de l'addition (D+E) de la quatrième et de la cinquième entrée (D, E) du bloc opérateur, soit le résultat de la soustraction (D-E) de la cinquième entrée (E) à la quatrième entrée (D) du bloc opérateur, soit le minimum (min(D, E)) de la quatrième et de la cinquième entrée (D, E) du bloc opérateur, soit le maximum (max(D, E)) de la quatrième et de la cinquième entrée (D, E) du bloc opérateur, soit le minimum (min(A, B, D)) de la première, de la deuxième et de la quatrième entrée (A, B, D) du bloc opérateur, soit le maximum (max(A, B, D)) de la première, de la deuxième et de la quatrième entrée (A, B, D) du bloc opérateur,

la troisième sortie (S) du bloc opérateur étant apte à délivrer soit le résultat de l'addition (S0+C) de la première sortie (S0) et de la troisième entrée (C) du bloc opérateur, soit le résultat de la soustraction (S0-C) de la troisième entrée (C) à la première sortie (S0) du bloc opérateur.

2. Module reconfigurable selon la revendication 1, **caractérisé en ce que** le bloc opérateur comprend trois additionneurs/soustracteurs et quatre blocs logiques, la première et la deuxième entrée (A, B) du bloc opérateur étant respectivement reliées à une première et à une seconde entrée d'un premier additionneur/soustracteur (add 1) et à une première et à une deuxième entrée d'un premier bloc logique (mux A/B), une sortie du premier additionneur/ soustracteur (add 1) étant reliée à une troisième entrée du premier bloc logique (mux A/B), une sortie du premier bloc logique (mux A/B) formant la première sortie (S0) du bloc opérateur,

la quatrième entrée (D) du bloc opérateur étant reliée à une première entrée d'un deuxième additionneur/ soustracteur (add 2) et à une première entrée d'un deuxième bloc logique (mux D/E), la cinquième entrée (E) du bloc opérateur étant reliée à une première entrée d'un troisième bloc logique (mux E/S), une sortie du troisième bloc logique (mux E/S) étant reliée à une seconde entrée du deuxième additionneur/soustracteur (add 2) et à une deuxième entrée du deuxième bloc logique (mux D/E), une sortie du deuxième additionneur/soustracteur (add 2) étant reliée à une troisième entrée du deuxième bloc logique (mux D/E), une sortie du deuxième bloc logique (mux D/E) formant la deuxième sortie (S1) du bloc opérateur,

la troisième entrée (C) du bloc opérateur et la sortie du premier bloc logique (mux A/B) étant respectivement reliées à une première et à une deuxième entrée d'un quatrième bloc logique (mux ABC), une première et une seconde sortie du quatrième bloc logique (mux ABC) étant respectivement reliées à une première et à une seconde entrée d'un troisième additionneur/soustracteur (add 3), une sortie du troisième additionneur/soustracteur (add 3) étant reliée à une seconde entrée du troisième bloc logique (mux E/S) et formant la troisième sortie (S) du bloc opérateur.

3. Module reconfigurable selon la revendication 2, **caractérisé en ce qu'**il comporte des moyens pour que la sortie (S0) du premier bloc logique (mux A/B) et la sortie (S1) du deuxième bloc logique (mux D/E) puissent être déterminées, respectivement, en fonction du signe de la soustraction (A-B) de la deuxième entrée (B) à la première entrée (A) du premier additionneur/ soustracteur (add 1) et en fonction du signe de la soustraction (D-E ou D-S) de la deuxième entrée (E ou S) à la première entrée (D) du deuxième additionneur/soustracteur (add 2).

4. Module reconfigurable selon l'une quelconque des revendications précédentes, **caractérisé en ce qu'**il comporte deux entrées (I, I_ch), deux sorties (O, O_ch), un cinquième bloc logique (mux I) et un sixième bloc logique (mux O), la première entrée (I) du module reconfigurable étant reliée à une première entrée du cinquième bloc logique (mux I) et à une première entrée du sixième bloc logique (mux O), la deuxième entrée (I_ch) du module reconfigurable étant reliée à une deuxième entrée du cinquième bloc logique (mux I), une première, une deuxième et une troisième sortie du cinquième bloc logique (mux I) étant respectivement reliées à la première, à la deuxième et à la quatrième entrée (A, B, D) du bloc opérateur, les première, deuxième et troisième sorties (S0, S1, S) du bloc opérateur étant respectivement reliées à une deuxième, à une troisième et à une quatrième entrée du sixième bloc logique (mux O), une sortie du sixième bloc logique (mux O) formant la première sortie (O) du module reconfigurable et une quatrième sortie du cinquième bloc logique (mux I) formant la seconde sortie (O_ch) du module reconfigurable, cette seconde sortie (O_ch) étant apte à être reliée à la seconde entrée (I_ch) d'un deuxième module reconfigurable selon la présente revendication.

5. Module reconfigurable selon la revendication 4, **caractérisé en ce qu'**il comporte une pile FIFO et un septième bloc logique (mux B), la deuxième sortie du cinquième bloc logique (mux I) étant reliée à une première entrée du septième bloc logique (mux B), une sortie du septième bloc logique (mux B) étant reliée à la deuxième entrée (B) du bloc opérateur, la première sortie (S0) du bloc opérateur étant reliée à une entrée de la pile FIFO, une sortie de la pile FIFO étant reliée à une deuxième entrée du septième bloc logique (mux B) et à une cinquième entrée du sixième bloc logique (mux O).

6. Module reconfigurable selon l'une quelconque des revendications 4 ou 5, **caractérisé en ce qu'**il comprend un huitième, un neuvième et un dixième bloc logique (mux A, mux D, mux E), les première et troisième sorties du cinquième bloc logique (mux I) étant respectivement reliées à une première entrée du huitième bloc logique (mux A) et à une première entrée du neuvième bloc logique (mux D), la troisième sortie (S) du bloc opérateur étant reliée à une deuxième entrée du huitième bloc logique (mux A), à une deuxième entrée du neuvième bloc logique (mux D) et à la troisième entrée (C) du bloc opérateur, les deuxième et troisième sorties (S1, S) du bloc opérateur étant respectivement reliées à une première et à une deuxième entrée du dixième bloc logique (mux E), une sortie du dixième bloc logique (mux E) étant reliée à la cinquième entrée (E) du bloc opérateur.

**7.** Module reconfigurable selon l'une quelconque des revendications précédentes, **caractérisé en ce qu'**il comprend un registre de données (reg C) et un onzième bloc logique (mux C), la troisième sortie (S) du bloc opérateur et le registre de données (reg C) étant respectivement reliés à une première et à une deuxième entrée du onzième bloc logique (mux C), une sortie du onzième bloc logique (mux C) étant reliée à la troisième entrée (C) du bloc opérateur.

**8.** Procédé de mise en oeuvre d'un module reconfigurable selon l'une quelconque des revendications précédentes, **caractérisé en ce qu'**il comprend une étape consistant à déterminer, à partir d'une image originale comprenant M lignes et N colonnes de pixels p(m,n), M et N étant des entiers positifs,

- soit une image intégrale,
- soit une image érodée,
- soit une image dilatée,
- soit une image distance de Manhattan,
- soit une projection suivant les lignes et une projection suivant les colonnes de l'image originale,
en fonction du type d'opération d'additionneurs/soustracteurs appartenant au bloc opérateur et de liaisons établies entre des entrées et des sorties de blocs logiques appartenant au bloc opérateur, l'image intégrale, l'image érodée, l'image dilatée et l'image distance de Manhattan ayant la même dimension que l'image originale.

**9.** Procédé selon la revendication 8 mettant en oeuvre un module reconfigurable selon les revendications 1 et 4 à 6, **caractérisé en ce que**, à chaque pixel p(m,n) de l'image originale est associé un poids wo(m,n) et à chaque pixel p(m,n) de l'image intégrale est associé un poids wi(m,n), la détermination de l'image intégrale comportant les étapes suivantes :

- définir une image intermédiaire de même dimension que l'image originale, à chaque pixel p(m,n) de l'image intermédiaire étant associé un poids wii(m,n),
- initialiser les poids wii(1,n) des pixels p(1,n) de la première ligne (m=1) de l'image intermédiaire,
- réitérer les étapes suivantes pour n variant de 2 à N :

  ◦ réitérer les étapes suivantes pour m variant de 2 à M, les poids wo(m,n) étant injectés sur la première entrée (I) du module reconfigurable, les cinquième et huitième blocs logiques (mux I, mux A) reliant la première entrée (I) du module reconfigurable à la première entrée (A) du bloc opérateur, le bloc opérateur réalisant une addition des poids wo(m,n) et wii(m-1,n), le sixième bloc logique (mux 0) reliant la première sortie (S0) du bloc opérateur à la première sortie (O) du module reconfigurable, le septième bloc logique (mux B) reliant la sortie de la pile FIFO à la deuxième entrée (B) du bloc opérateur :

    ■ additionner le poids wo(m,n) des pixels p(m,n) de l'image originale avec le poids wii(m-1,n) des pixels p(m-1,n) de l'image intermédiaire,
    ■ stocker les résultats des additions dans la pile FIFO, la pile FIFO étant de taille M-1,

- initialiser les poids wi(m,1) des pixels p(m,1) de la première colonne (n=1) de l'image intégrale,
- réitérer les étapes suivantes pour m variant de 2 à M :

  ◦ réitérer les étapes suivantes pour n variant de 2 à N, les poids wii(m,n) étant injectés sur la première entrée (I) du module reconfigurable, les cinquième et huitième blocs logiques (mux I, mux A) reliant la première entrée (I) du module reconfigurable à la première entrée (A) du bloc opérateur, le bloc opérateur réalisant l'addition des poids wii(m,n) et wi(m,n-1), le sixième bloc logique (mux O) reliant la première sortie (S0) du bloc opérateur à la première sortie (O) du module reconfigurable, le septième bloc logique (mux B) reliant la sortie de la pile FIFO à la deuxième entrée B du bloc opérateur :

    ■ additionner le poids wii(m,n) des pixels p(m,n) de l'image intermédiaire avec le poids wi(m,n-1) des pixels p(m,n-1) de l'image intégrale.
    ■ stocker les résultats des additions dans la pile FIFO, la pile FIFO étant de taille N-1.

**10.** Procédé selon l'une quelconque des revendications 8 ou 9 mettant en oeuvre un module reconfigurable selon les revendications 1 et 4 à 6, **caractérisé en ce que**, à chaque pixel p(m,n) de l'image originale est associé un poids wo(m,n) et à chaque pixel p(m,n) de l'image érodée est associé un poids we(m,n), la détermination de l'image érodée par un élément structurant de dimension 3x3 comportant les étapes suivantes :

- décomposer l'élément structurant en un premier sous-élément structurant de dimension 1x3 et en un second sous-élément structurant de dimension 3x1,
- définir une image intermédiaire de même dimension que l'image originale, à chaque pixel p(m,n) de l'image intermédiaire étant associé un poids wie(m,n),
- réitérer les étapes suivantes pour m variant de 1 à M :

   ∘ réitérer les étapes suivantes pour n variant de 1 à N :

      ■ attribuer au poids wie(m,n) le minimum des poids wo(x,y) des pixels p(x,y) appartenant au premier sous-élément structurant centré sur le pixel p(m,n) considéré,

- réitérer les étapes suivantes pour n variant de 1 à N :

   ∘ réitérer les étapes suivantes pour m variant de 1 à M :

      ■ attribuer au poids we(m,n) le minimum des poids wie(x,y) des pixels p(x,y) appartenant au second sous-élément structurant centré sur le pixel p(m,n) considéré,
      les poids wo(x,y) ou wie(x,y) étant injectés sur la première entrée (I) du module reconfigurable, le cinquième bloc logique (mux I) reliant successivement la première entrée (I) du module reconfigurable à la première entrée (A) du bloc opérateur via le huitième bloc logique (mux A), à la deuxième entrée (B) du bloc opérateur via le septième bloc logique (mux B), et à la quatrième entrée (D) du bloc opérateur via le neuvième bloc logique (mux D), le dixième bloc logique (mux E) reliant la troisième sortie (S) à la cinquième entrée (E) du bloc opérateur, le bloc opérateur déterminant le minimum des poids wo(x, y) ou wie(x,y) des pixels p(x,y) appartenant au premier ou au second sous-élément structurant centré sur le pixel p(m,n), le sixième bloc logique (mux O) reliant la deuxième sortie (S1) du bloc opérateur à la première sortie (O) du module reconfigurable.

**11.** Procédé selon la revendication 10 mettant en oeuvre un module reconfigurable selon les revendications 1 à 6, **caractérisé en ce que** l'attribution au poids wie(m,n) ou we(m,n) du minimum des poids wo(x,y) ou wie(x,y) des pixels p(x,y) appartenant au premier ou au second sous-élément structurant comprend les étapes suivantes :

- soustraire la deuxième entrée (B) à la première entrée (A) du premier additionneur/soustracteur (add 1),
- établir une liaison entre la première ou la deuxième entrée (A, B) et la sortie du premier bloc logique (mux A/B) en fonction du signe du résultat de la soustraction (A-B),
- établir une liaison entre la deuxième entrée et la première sortie du quatrième bloc logique (mux ABC),
- additionner ou soustraire la première entrée du troisième additionneur/soustracteur (add 3) avec la valeur nulle,
- établir une liaison entre la première entrée et la sortie du troisième bloc logique (mux E/S),
- soustraire la deuxième entrée (E=S=A ou E=S=B) à la première entrée (D) du deuxième additionneur/soustracteur (add 2),
- établir une liaison entre la première ou la deuxième entrée (D, E=S=A ou E=S=B) et la sortie du deuxième bloc logique (mux D/E) en fonction du signe du résultat de la deuxième soustraction (D-E).

**12.** Procédé selon l'une quelconque des revendications 8 à 11 mettant en oeuvre un module reconfigurable selon les revendications 1 et 4 à 6, **caractérisé en ce que**, à chaque pixel p(m,n) de l'image originale est associé un poids wo(m,n) et à chaque pixel p(m,n) de l'image dilatée est associé un poids wf(m,n), la détermination de l'image dilatée par un élément structurant de dimension 3x3 comportant les étapes suivantes :

- décomposer l'élément structurant en un premier sous-élément structurant de dimension 1x3 et en un second sous-élément structurant de dimension 3x1,
- définir une image intermédiaire de même dimension que l'image originale, à chaque pixel p(m,n) de l'image intermédiaire étant associé un poids wif(m,n),
- réitérer les étapes suivantes pour m variant de 1 à M :

   ∘ réitérer les étapes suivantes pour n variant de 1 à N :

■ attribuer au poids wif(m,n) le maximum des poids wo(x,y) des pixels p(x,y) appartenant au premier sous-élément structurant centré sur le pixel p(m,n) considéré,

- réitérer les étapes suivantes pour n variant de 1 à N :

  ◦ réitérer les étapes suivantes pour m variant de 1 à M :

  ■ attribuer au poids wf(m,n) le maximum des poids wif(x,y) des pixels p(x,y) appartenant au second sous-élément structurant centré sur le pixel p(m,n) considéré,
  les poids wo(x,y) ou wie(x,y) étant injectés sur la première entrée (I) du module reconfigurable, le cinquième bloc logique (mux I) reliant successivement la première entrée (I) du module reconfigurable à la première entrée (A) du bloc opérateur via le huitième bloc logique (mux A), à la deuxième entrée (B) du bloc opérateur via le septième bloc logique (mux B), et à la quatrième entrée (D) du bloc opérateur via le neuvième bloc logique (mux D), le dixième bloc logique (mux E) reliant la troisième sortie (S) à la cinquième entrée (E) du bloc opérateur, le bloc opérateur déterminant le maximum des poids wo(x, y) ou wif(x,y) des pixels p(x,y) appartenant au premier ou au second sous-élément structurant centré sur le pixel p(m,n), le sixième bloc logique (mux O) reliant la deuxième sortie (S1) du bloc opérateur à la première sortie (O) du module reconfigurable.

13. Procédé selon la revendication 12 mettant en oeuvre un module reconfigurable selon les revendications 1 à 6, **caractérisé en ce que** l'attribution au poids wif(m,n) ou wf(m,n) du maximum des poids wo(x,y) ou wif(x,y) des pixels p(x,y) appartenant au premier ou au second sous-élément structurant comprend les étapes suivantes :

- soustraire la deuxième entrée (B) à la première entrée (A) du premier additionneur/soustracteur (add 1),
- établir une liaison entre la première ou la deuxième entrée (A, B) et la sortie du premier bloc logique (mux A/B) en fonction du signe du résultat de la soustraction (A-B),
- établir une liaison entre la deuxième entrée et la première sortie du quatrième bloc logique (mux ABC),
- additionner ou soustraire la première entrée du troisième additionneur/soustracteur (add 3) avec la valeur nulle,
- établir une liaison entre la première entrée et la sortie du troisième bloc logique (mux E/S),
- soustraire la deuxième entrée (E=S=A ou E=S=B) à la première entrée (D) du deuxième additionneur/soustracteur (add 2),
- établir une liaison entre la première ou la deuxième entrée (D, E=S=A ou E=S=B) et la sortie du deuxième bloc logique (mux D/E) en fonction du signe du résultat de la deuxième soustraction (D-E).

14. Procédé selon l'une quelconque des revendications 8 à 13 mettant en oeuvre un module reconfigurable selon les revendications 1 et 4 à 6, **caractérisé en ce que**, à chaque pixel p(m,n) de l'image originale est associé un poids wo(m,n) et à chaque pixel p(m,n) de l'image distance est associé un poids wd(m,n), le poids wo(m,n) pouvant prendre deux valeurs, une première valeur (1) indiquant que le pixel p(m,n) considéré appartient à un objet, une seconde valeur (0) indiquant que ledit pixel p(m,n) n'appartient pas à l'objet, la détermination de l'image distance comportant les étapes suivantes :

- définir une image intermédiaire de mêmes dimension que l'image originale, à chaque pixel p(m,n) de l'image intermédiaire étant associé un poids wid(m,n),
- définir un premier élément structurant composé de trois pixels, un pixel central p(m,n), un pixel p(m,n-1) situé sur la même ligne que le pixel central p(m,n) à la colonne précédente et un pixel p(m-1,n) situé sur la même colonne que le pixel central p(m,n) à la ligne précédente,
- réitérer les étapes suivantes pour m variant de 1 à M :

  o réitérer les étapes suivantes pour n variant de 1 à N, le septième bloc logique (mux B) reliant la sortie de la pile FIFO à la deuxième entrée (B) du bloc opérateur, le huitième bloc logique (mux A) reliant la troisième sortie (S) à la première entrée (A) du bloc opérateur :

  ■ déterminer si le pixel central p(m,n) appartient à l'objet,

  • si tel est le cas, attribuer au poids wid(m,n) la valeur nulle, le sixième bloc logique (mux O) reliant la première entrée (I) du module reconfigurable à la première sortie (O) du module reconfigurable,
  • si tel n'est pas le cas, attribuer au poids wid(m,n) le minimum des poids wid(m,n-1) $(V_1)$ et wid(m-1,n) $(B_1)$ incrémentés d'une unité, le sixième bloc logique (mux O) reliant la troisième sortie

(S) du bloc opérateur à la première sortie (O) du module reconfigurable,

- définir un second élément structurant composé de trois pixels, un pixel central p(m,n), un pixel p(m+1,n) situé sur la même colonne que le pixel central p(m,n) à la ligne suivante et un pixel p(m,n+1) situé sur la même ligne que le pixel central à la colonne suivante,
- réitérer les étapes suivantes pour m variant de M à 1 :

    o réitérer les étapes suivantes pour n variant de N à 1, les cinquième et neuvième blocs logiques (mux 1, mux D) reliant la première entrée (I) du module reconfigurable à la quatrième entrée (D) du bloc opérateur, le sixième bloc logique (mux O) reliant la deuxième sortie (S1) du bloc opérateur à la première sortie (O) du module reconfigurable, le septième bloc logique (mux B) reliant la sortie de la pile FIFO à la deuxième entrée (B) du bloc opérateur, le huitième bloc logique (mux A) reliant la troisième sortie (S) à la première entrée (A) du bloc opérateur :

        ■ attribuer au poids wd(m,n) du pixel central p(m,n) le minimum des poids wid(m,n) (r), wd(m+1,n)+1 ($B_2$+1) et wd(m,n+1)+1 ($V_2$+1).

**15.** Procédé selon la revendication 14 mettant en oeuvre un module reconfigurable selon les revendications 1 à 7, **caractérisé en ce que** l'attribution au poids wid(m,n) du minimum des poids wid(m,n-1) ($V_1$) et wid(m-1,n) ($B_1$) incrémentés d'une unité comprend les étapes suivantes :

- soustraire la deuxième entrée (B=$B_1$) à la première entrée (A=$V_1$) du premier additionneur/soustracteur (add 1),
- établir une liaison entre la première ou la deuxième entrée (A, B) et la sortie du premier bloc logique (mux A/B) en fonction du signe du résultat de la soustraction (A-B),
- établir une liaison entre la deuxième entrée (A ou B) et la première sortie et entre la première entrée (C) et la deuxième sortie du quatrième bloc logique (mux ABC),
- additionner la première entrée du troisième additionneur/soustracteur (add 3) avec la valeur "un", le onzième bloc logique (mux C) reliant le registre de données (reg C) à la troisième entrée (C) du bloc opérateur.

**16.** Procédé selon l'une quelconque des revendications 14 ou 15 mettant en oeuvre un module reconfigurable selon les revendications 1 à 7, **caractérisé en ce que** l'attribution au poids wd(m,n) du minimum des poids wid(m,n) (r), wd(m+1,n)+1 ($B_2$+1) et wd(m,n+1)+1 ($V_2$+1) comprend les étapes suivantes :

- soustraire la deuxième entrée (B=$B_2$) à la première entrée (A=$V_2$) du premier additionneur/soustracteur (add 1),
- établir une liaison entre la première ou la deuxième entrée (A, B) et la sortie du premier bloc logique (mux A/B) en fonction du signe du résultat de la soustraction (A-B),
- établir une liaison entre la deuxième entrée (A ou B) et la première sortie et entre la première entrée (C) et la deuxième sortie du quatrième bloc logique (mux ABC),
- additionner la première entrée du troisième additionneur/soustracteur (add 3) avec la valeur "un", le onzième bloc logique (mux C) reliant le registre de données (reg C) à la troisième entrée (C) du bloc opérateur,
- établir une liaison entre la sortie du troisième additionneur/ soustracteur (add 3) et la deuxième entrée du deuxième additionneur/ soustracteur (add 2) via le troisième bloc logique (mux E/S),
- soustraire la deuxième entrée ($B_2$+1 ou $V_2$+1) à la première entrée (D=r) du deuxième additionneur/soustracteur (add 2),
- établir une liaison entre la première ou la deuxième entrée (r, $B_2$+1 ou $V_2$+1) et la sortie du deuxième bloc logique (mux D/E) en fonction du signe du résultat de la soustraction (r-($B_2$+1 ou r-($V_2$+1)).

**17.** Procédé selon l'une quelconque des revendications 8 à 16 mettant en oeuvre un module reconfigurable selon la revendication 1, **caractérisé en ce que**, à chaque pixel p(m,n) de l'image originale est associé un poids wo(m,n), la détermination des projections suivant les lignes et suivant les colonnes de l'image originale comportant les étapes suivantes :

- définir une ligne de projection comportant le même nombre N de colonnes que les lignes de l'image originale et une colonne de projection comportant le même nombre M de lignes que les colonnes de l'image originale, à chaque pixel p(X,n) de la ligne de projection et à chaque pixel p(m,Y) de la colonne de projection étant associé respectivement un poids wp(X,n) et wp(m,Y),
- réitérer les étapes suivantes pour m variant de 1 à M :

○ réitérer les étapes suivantes pour n variant de 1 à N :

■ additionner le poids wp(m,Y) des pixels p(m,Y) de la colonne de projection avec le poids wo(m,n) des pixels p(m,n) de l'image originale,
■ additionner le poids wp(X,n) des pixels p(X,n) de la ligne de projection avec le poids wo(m,n) des pixels p(m,n) de l'image originale.

**Claims**

1. A reconfigurable module, **characterized in that** it comprises an operational block comprising five inputs (A, B, C, D, E) and three outputs (S0, S1, S),
the first output (S0) of the operational block being capable of delivering either the result of the addition (A+B) of the first and second inputs (A, B) of the operational block, or the result of the subtraction (A-B) of the second input (B) from the first input (A) of the operational block, or the minimum (min(A, B)) of the first and second inputs (A, B) of the operational block, or the maximum (max(A, B)) of the first and second inputs (A, B) of the operational block,
the second output (S1) of the operational block being capable of delivering either the result of the addition (D+E) of the fourth and fifth inputs (D, E) of the operational block, or the result of the subtraction (D-E) of the fifth input (E) from the fourth input (D) of the operational block, or the minimum (min(D, E)) of the fourth and fifth inputs (D, E) of the operational block, or the maximum (max(D, E)) of the fourth and fifth inputs (D, E) of the operational block, or the minimum (min(A, B, D)) of the first, second and fourth inputs (A, B, D) of the operational block, or the maximum (max(A, B, D)) of the first, second and fourth inputs (A, B, D) of the operational block,
the third output (S) of the operational block being capable of delivering either the result of the addition (S0+C) of the first output (S0) and the third input (C) of the operational block, or the result of the subtraction (S0-C) of the third input (C) from the first output (S0) of the operational block.

2. The reconfigurable module as claimed in claim 1, **characterized in that** the operational block comprises three adders/subtracters and four logic blocks, the first and second inputs (A, B) of the operational block being respectively connected to a first and to a second input of a first adder/subtracter (add 1) and to a first and to a second input of a first logic block (mux A/B), an output of the first adder/subtracter (add 1) being connected to a third input of the first logic block (mux A/B), an output of the first logic block (mux A/B) forming the first output (S0) of the operational block,
the fourth input (D) of the operational block being connected to a first input of a second adder/subtracter (add 2) and to a first input of a second logic block (mux D/E), the fifth input (E) of the operational block being connected to a first input of a third logic block (mux E/S), an output of the third logic block (mux E/S) being connected to a second input of the second adder/subtracter (add 2) and to a second input of the second logic block (mux D/E), an output of the second adder/subtracter (add 2) being connected to a third input of the second logic block (mux D/E), an output of the second logic block (mux D/E) forming the second output (S1) of the operational block,
the third input (C) of the operational block and the output of the first logic block (mux A/B) being respectively connected to a first and to a second input of a fourth logic block (mux ABC), a first and a second output of the fourth logic block (mux ABC) being respectively connected to a first and to a second input of a third adder/subtracter (add 3), an output of the third adder/subtracter (add 3) being connected to a second input of the third logic block (mux E/S) and forming the third output (S) of the operational block.

3. The reconfigurable module as claimed in claim 2, **characterized in that** it comprises means such that the output (S0) of the first logic block (mux A/B) and the output (S1) of the second logic block (mux D/E) may be determined, respectively, as a function of the sign of the subtraction (A-B) of the second input (B) from the first input (A) of the first adder/ subtracter (add 1) and as a function of the sign of the subtraction (D-E or D-S) of the second input (E or S) from the first input (D) of the second adder/subtracter (add 2).

4. The reconfigurable module as claimed in any one of the preceding claims, **characterized in that** it comprises two inputs (I, I_ch), two outputs (O, O_ch), a fifth logic block (mux I) and a sixth logic block (mux O), the first input (I) of the reconfigurable module being connected to a first input of the fifth logic block (mux I) and to a first input of the sixth logic block (mux O), the second input (I_ch) of the reconfigurable module being connected to a second input of the fifth logic block (mux I), a first, a second and a third output of the fifth logic block (mux I) being respectively connected to the first, to the second and to the fourth input (A, B, D) of the operational block, the first, second and third outputs (S0, S1, S) of the operational block being respectively connected to a second, to a third and to a fourth input of the sixth logic block (mux O), an output of the sixth logic block (mux O) forming the first output (O) of the reconfigurable module and a fourth output of the fifth logic block (mux I) forming the second output (O_ch) of the reconfigurable module, where this second output (O_ch) is able to be connected to the second input (I_ch) of a second reconfigurable module as claimed in the present claim.

5. The reconfigurable module as claimed in claim 4, **characterized in that** it comprises a FIFO stack and a seventh logic block (mux B), the second output of the fifth logic block (mux I) being connected to a first input of the seventh logic block (mux B), an output of the seventh logic block (mux B) being connected to the second input (B) of the operational block, the first output (S0) of the operational block being connected to an input of the FIFO stack, an output of the FIFO stack being connected to a second input of the seventh logic block (mux B) and to a fifth input of the sixth logic block (mux O).

6. The reconfigurable module as claimed in either one of claims 4 and 5, **characterized in that** it comprises an eighth, a ninth and a tenth logic block (mux A, mux D, mux E), the first and third outputs of the fifth logic block (mux I) being respectively connected to a first input of the eighth logic block (mux A) and to a first input of the ninth logic block (mux D), the third output (S) of the operational block being connected to a second input of the eighth logic block (mux A), to a second input of the ninth logic block (mux D) and to the third input (C) of the operational block, the second and third outputs (S1, S) of the operational block being respectively connected to a first and to a second input of the tenth logic block (mux E), an output of the tenth logic block (mux E) being connected to the fifth input (E) of the operational block.

7. The reconfigurable module as claimed in any one of the preceding claims, **characterized in that** it comprises a data register (reg C) and an eleventh logic block (mux C), the third output (S) of the operational block and the data register (reg C) being respectively connected to a first and to a second input of the eleventh logic block (mux C), an output of the eleventh logic block (mux C) being connected to the third input (C) of the operational block.

8. A method of implementing a reconfigurable module as claimed in any one of the preceding claims, **characterized in that** it comprises a step consisting in determining, starting from an original image comprising M rows and N columns of pixels p(m,n), M and N being positive integers,

    - either an integral image,
    - or an eroded image,
    - or an expanded image,
    - or a Manhattan distance image,
    - or a projection along the rows and a projection along the columns of the original image,

    depending on the type of operation of adders/subtracters belonging to the operational block and of links established between inputs and outputs of logic blocks belonging to the operational block, the integral image, the eroded image, the expanded image and the Manhattan distance image having the same dimensions as the original image.

9. Method as claimed in claim 8 implementing a reconfigurable module as claimed in claims 1 and 4 to 6, **characterized in that** a weighting wo(m,n) is associated with each pixel p(m,n) of the original image and a weighting wi(m,n) is associated with each pixel p(m,n) of the integral image, the determination of the integral image comprising the following steps:

    - define an intermediate image of same dimensions as the original image, a weighting wii(m,n) being associated with each pixel p(m,n) of the intermediate image,
    - initialize the weightings wii(1,n) of the pixels p(1,n) of the first row (m=1) of the intermediate image,
    - iterate the following steps for n varying from 2 to N:

        ∘ iterate the following steps for m varying from 2 to M, the weighting wo(m,n) being injected into the first input (I) of the reconfigurable module, the fifth and eighth logic blocks (mux I, mux A) connecting the first input (I) of the reconfigurable module to the first input (A) of the operational block, the operational block carrying out an addition of the weightings wo(m,n) and wii(m-1,n), the sixth logic block (mux O) connecting the first output (S0) of the operational block to the first output (O) of the reconfigurable module, the seventh logic block (mux B) connecting the output of the FIFO stack to the second input (B) of the operational block:

            ■ add the weightings wo(m,n) of the pixels p(m,n) of the original image to the weightings wii(m-1,n) of the pixels p(m-1,n) of the intermediate image,

■ store the results of the additions in the FIFO stack, the FIFO stack being of size M-1,

- initialize the weightings wi(m,1) of the pixels p(m,1) of the first column (n=1) of the integral image,
- iterate the following steps for m varying from 2 to M:

o iterate the following steps for n varying from 2 to N, the weighting wii(m,n) being injected into the first input (I) of the reconfigurable module, the fifth and eighth logic blocks (mux I, mux A) connecting the first input (I) of the reconfigurable module to the first input (A) of the operational block, the operational block performing the addition of the weightings wii(m,n) and wi(m,n-1), the sixth logic block (mux O) connecting the first output (S0) of the operational block to the first output (O) of the reconfigurable module, the seventh logic block (mux B) connecting the output of the FIFO stack to the second input B of the operational block:

■ add the weightings wii(m,n) of the pixels p(m,n) of the intermediate image to the weightings wi(m,n-1) of the pixels p(m,n-1) of the integral image.
■ store the results of the additions in the FIFO stack, the FIFO stack being of size N-1.

10. The method as claimed in either one of claims 8 and 9 implementing a reconfigurable module as claimed in claims 1 and 4 to 6, **characterized in that** a weighting wo(m,n) is associated with each pixel p(m,n) of the original image and a weighting we(m,n) is associated with each pixel p(m,n) of the eroded image, the determination of the eroded image by a structural element with dimensions 3x3 comprising the following steps:

- decompose the structural element into a first sub-structural element with dimensions 1x3 and into a second sub-structural element with dimensions 3x1,
- define an intermediate image of same dimensions as the original image, a weighting wie(m,n) being associated with each pixel p(m,n) of the intermediate image,
- iterate the following steps for m varying from 1 to M:

∘ iterate the following steps for n varying from 1 to N:

■ assign to the weighting wie(m,n) the minimum of the weightings wo(x,y) of the pixels p(x,y) belonging to the first sub-structural element centered on the pixel p(m,n) in question,

- iterate the following steps for n varying from 1 to N:

∘ iterate the following steps for m varying from 1 to M:

■ assign to the weighting we(m,n) the minimum of the weightings wie(x,y) of the pixels p(x,y) belonging to the second sub-structural element centered on the pixel p(m,n) in question,
the weightings wo(x,y) or wie(x,y) being injected into the first input (I) of the reconfigurable module, the fifth logic block (mux I) successively connecting the first input (I) of the reconfigurable module to the first input (A) of the operational block via the eighth logic block (mux A), to the second input (B) of the operational block via the seventh logic block (mux B), and to the fourth input (D) of the operational block via the ninth logic block (mux D), the tenth logic block (mux E) connecting the third output (S) to the fifth input (E) of the operational block, the operational block determining the minimum of the weightings wo(x,y) or wie(x,y) of the pixels p(x,y) belonging to the first or to the second sub-structural element centered on the pixel p(m,n), the sixth logic block (mux O) connecting the second output (S1) of the operational block to the first output (O) of the reconfigurable module.

11. The method as claimed in claim 10 implementing a reconfigurable module as claimed in claims 1 to 6, **characterized in that** the assignment to the weightings wie(m,n) or we(m,n) of the minimum of the weightings wo(x,y) or wie(x,y) of the pixels p(x,y) belonging to the first or to the second sub-structural element comprises the following steps:

- subtract the second input (B) from the first input (A) of the first adder/subtracter (add 1),
- establish a link between the first or the second input (A, B) and the output of the first logic block (mux A/B) depending on the sign of the result of the subtraction (A-B),
- establish a link between the second input and the first output of the fourth logic block (mux ABC),
- add or subtract the first input of the third adder/subtracter (add 3) to or from the value zero,
- establish a link between the first input and the output of the third logic block (mux E/S),

- subtract the second input (E=S=A or E=S=B) from the first input (D) of the second adder/subtracter (add 2),
- establish a link between the first or the second input (D, E=S=A or E=S=B) and the output of the second logic block (mux D/E) depending on the sign of the result of the second subtraction (D-E).

12. The method as claimed in any one of claims 8 to 11 implementing a reconfigurable module as claimed in claims 1 and 4 to 6, **characterized in that** a weighting wo(m,n) is associated with each pixel p(m,n) of the original image and a weighting wf(m,n) is associated with each pixel p(m,n) of the expanded image, the determination of the expanded image by a structural element with dimensions 3x3 comprising the following steps:

- decompose the structural element into a first sub-structural element of dimension 1x3 and into a second sub-structural element of dimension 3x1,
- define an intermediate image of same dimensions as the original image, a weighting wif(m,n) being associated with each pixel p(m,n) of the intermediate image,
- iterate the following steps for m varying from 1 to M:

  ○ iterate the following steps for n varying from 1 to N:

    ■ assign to the weighting wif(m,n) the maximum of the weightings wo(x,y) of the pixels p(x,y) belonging to the first sub-structural element centered on the pixel p(m,n) in question,

- iterate the following steps for n varying from 1 to N:

  ○ iterate the following steps for m varying from 1 to M:

    ■ assign to the weighting wf(m,n) the maximum of the weightings wif(x,y) of the pixels p(x,y) belonging to the second sub-structural element centered on the pixel p(m,n) in question, the weightings wo(x,y) or wie(x,y) being injected into the first input (I) of the reconfigurable module, the fifth logic block (mux I) successively connecting the first input (I) of the reconfigurable module to the first input (A) of the operational block via the eighth logic block (mux A), to the second input (B) of the operational block via the seventh logic block (mux B), and to the fourth input (D) of the operational block via the ninth logic block (mux D), the tenth logic block (mux E) connecting the third output (S) to the fifth input (E) of the operational block, the operational block determining the maximum of the weightings wo(x,y) or wif(x,y) of the pixels p(x,y) belonging to the first or to the second sub-structural element centered on the pixel p(m,n), the sixth logic block (mux O) connecting the second output (S1) of the operational block to the first output (O) of the reconfigurable module.

13. The method as claimed in claim 12 implementing a reconfigurable module as claimed in claims 1 to 6, **characterized in that** the assignment to the weighting wif(m,n) or wf(m,n) of the maximum of the weightings wo(x,y) or wif(x,y) of the pixels p(x,y) belonging to the first or to the second sub-structural element comprises the following steps:

- subtract the second input (B) from the first input (A) of the first adder/subtracter (add 1),
- establish a link between the first or the second input (A, B) and the output of the first logic block (mux A/B) depending on the sign of the result of the subtraction (A-B),
- establish a link between the second input and the first output of the fourth logic block (mux ABC),
- add or subtract the first input of the third adder/subtracter (add 3) to or from the value zero,
- establish a link between the first input and the output of the third logic block (mux E/S),
- subtract the second input (E=S=A or E=S=B) from the first input (D) of the second adder/subtracter (add 2),
- establish a link between the first or the second input (D, E=S=A or E=S=B) and the output of the second logic block (mux D/E) depending on the sign of the result of the second subtraction (D-E).

14. The method as claimed in any one of claims 8 to 13 implementing a reconfigurable module as claimed in claims 1 and 4 to 6, **characterized in that** a weighting wo(m,n) is associated with each pixel p(m,n) of the original image and a weighting wd(m,n) is associated with each pixel p(m,n) of the distance image, where the weighting wo(m,n) is able to take two values, a first value (1) indicating that the pixel p(m,n) in question belongs to an object, a second value (0) indicating that said pixel p(m,n) does not belong to the object, the determination of the distance image comprising the following steps:

- define an intermediate image of same dimensions as the original image, a weighting wid(m,n) being associated with each pixel p(m,n) of the intermediate image,
- define a first structural element composed of three pixels, a central pixel p(m,n), a pixel p(m,n-1) situated on the same row as the central pixel p(m,n) in the preceding column and a pixel p(m-1,n) situated on the same column as the central pixel p(m,n) in the preceding row,
- iterate the following steps for m varying from 1 to M:

   o iterate the following steps for n varying from 1 to N, the seventh logic block (mux B) connecting the output of the FIFO stack to the second input (B) of the operational block, the eighth logic block (mux A) connecting the third output (S) to the first input (A) of the operational block:

      ■ determine whether the central pixel p(m,n) belongs to the object,

         • if such is the case, assign the value zero to the weighting wid(m,n), the sixth logic block (mux O) connecting the first input (I) of the reconfigurable module to the first output (O) of the reconfigurable module,
         • otherwise, assign to the weighting wid(m,n) the minimum of the weightings wid(m,n-1) ($V_1$) and wid(m-1,n) ($B_1$) incremented by one unit, the sixth logic block (mux O) connecting the third output (S) of the operational block to the first output (O) of the reconfigurable module,

   - define a second structural element composed of three pixels, a central pixel p(m,n), a pixel p(m+1,n) situated on the same column as the central pixel p(m,n) in the following row and a pixel p(m,n+1) situated on the same row as the central pixel in the following column,
   - iterate the following steps for m varying from M to 1:

      ○ iterate the following steps for n varying from N to 1, the fifth and ninth logic blocks (mux I, mux D) connecting the first input (I) of the reconfigurable module to the fourth input (D) of the operational block, the sixth logic block (mux O) connecting the second output (S1) of the operational block to the first output (O) of the reconfigurable module, the seventh logic block (mux B) connecting the output of the FIFO stack to the second input (B) of the operational block, the eighth logic block (mux A) connecting the third output (S) to the first input (A) of the operational block:

         ■ assign to the weighting wd(m,n) of the central pixel p(m,n) the minimum of the weightings wid(m,n) (r), wd(m+1,n)+1 ($B_2$+1) and wd(m,n+1)+1 ($V_2$+1).

**15.** The method as claimed in claim 14 implementing a reconfigurable module as claimed in claims 1 to 7, **characterized in that** the assignment to the weighting wid(m,n) of the minimum of the weightings wid(m,n-1) ($V_1$) and wid(m-1,n) ($B_1$) incremented by one unit comprises the following steps:

   - subtract the second input (B=$B_1$) from the first input (A=$V_1$) of the first adder/subtracter (add 1),
   - establish a link between the first or the second input (A, B) and the output of the first logic block (mux A/B) depending on the sign of the result of the subtraction (A-B),
   - establish a link between the second input (A or B) and the first output and between the first input (C) and the second output of the fourth logic block (mux ABC),
   - add the value "one" to the first input of the third adder/subtracter (add 3), the eleventh logic block (mux C) connecting the data register (reg C) to the third input (C) of the operational block.

**16.** The method as claimed in either one of claims 14 and 15 implementing a reconfigurable module as claimed in claims 1 to 7, **characterized in that** the assignment to the weighting wd(m,n) of the minimum of the weightings wid(m,n) (r), wd(m+1,n)+1 ($B_2$+1) and wd(m,n+1)+1 ($V_2$+1) comprises the following steps:

   - subtract the second input (B=$B_2$) from the first input (A=$V_2$) of the first adder/subtracter (add 1),
   - establish a link between the first or the second input (A, B) and the output of the first logic block (mux A/B) depending on the sign of the result of the subtraction (A-B),
   - establish a link between the second input (A or B) and the first output and between the first input (C) and the second output of the fourth logic block (mux ABC),
   - add the value "one" to the first input of the third adder/subtracter (add 3), the eleventh logic block (mux C) connecting the data register (reg C) to the third input (C) of the operational block,
   - establish a link between the output of the third adder/subtracter (add 3) and the second input of the second adder/subtracter (add 2) via the third logic block (mux E/S),
- subtract the second input ($B_2$+1 or $V_2$+1) from the first input (D=r) of the second adder/subtracter (add 2),
- establish a link between the first or the second input (r, $B_2$+1 or $V_2$+1) and the output of the second logic block (mux D/E) depending on the sign of the result of the subtraction (r-($B_2$+1 or r-($V_2$+1)).

17. The method as claimed in any one of claims 8 to 16 implementing a reconfigurable module as claimed in claim 1, **characterized in that** a weighting wo(m,n) is associated with each pixel p(m,n) of the original image, the determination of the projections along the rows and along the columns of the original image comprising the following steps:

- define a projection row comprising the same number N of columns as the rows of the original image and a projection column comprising the same number M of rows as the columns of the original image, a weighting wp(X,n) and wp(m,Y) being associated with each pixel p(X,n) of the projection row and with each pixel p(m,Y) of the projection column, respectively,
- iterate the following steps for m varying from 1 to M:

  ◦ iterate the following steps for n varying from 1 to N:

    ■ add the weightings wp(m,Y) of the pixels p(m,Y) of the projection column to the weightings wo(m,n) of the pixels p(m,n) of the original image,
    ■ add the weightings wp(X,n) of the pixels p(X,n) of the projection row to the weightings wo(m,n) of the pixels p(m,n) of the original image.

**Patentansprüche**

1. Rekonfigurierbares Modul, **dadurch gekennzeichnet, dass** es einen Operatorblock aufweist, der fünf Eingänge (A, B, C, D, E) und drei Ausgänge (S0, S1, S) umfasst,
wobei der erste Ausgang (S0) des Operatorblocks imstande ist, entweder das Ergebnis der Addition (A+B) des ersten und des zweiten Eingangs (A, B) des Operatorblocks oder das Ergebnis der Subtraktion (A-B) des zweiten Eingangs (B) vom ersten Eingang (A) des Operatorblocks oder das Minimum (min(A, B)) des ersten und des zweiten Eingangs (A, B) des Operatorblocks oder das Maximum (max(A, B)) des ersten und des zweiten Eingangs (A, B) des Operatorblocks bereitzustellen,
wobei der zweite Ausgang (S1) des Operatorblocks imstande ist, entweder das Ergebnis der Addition (D+E) des vierten und des fünften Eingangs (D, E) des Operatorblocks oder das Ergebnis der Subtraktion (D-E) des fünften Eingangs (E) vom vierten Eingang (D) des Operatorblocks oder das Minimum (min(D, E)) des vierten und des fünften Eingangs (D, E) des Operatorblocks oder das Maximum (max(D, E)) des vierten und des fünften Eingangs (A, B) des Operatorblocks oder das Minimum (min(A, B, D)) des ersten, des zweiten und des vierten Eingangs (A, B, D) des Operatorblocks oder das Maximum (max(A, B, D) des ersten, des zweiten und des vierten Eingangs (A, B, D) des Operatorblocks bereitzustellen,
wobei der dritte Ausgang (S) des Operatorblocks imstande ist, entweder das Ergebnis der Addition (S0+C) des ersten Ausgang (S0) und des dritten Eingang (C) des Operatorblocks oder das Ergebnis der Subtraktion (S0-C) des dritten Eingangs (C) vom ersten Ausgang (S0) des Operatorblocks bereitzustellen.

2. Rekonfigurierbares Modul nach Anspruch 1, **dadurch gekennzeichnet, dass** der Operatorblock drei Addierer/ Subtrahierer und vier logische Blöcke umfasst, wobei der erste und der zweite Eingang (A, B) des Operatorblocks jeweils mit einem ersten und einem zweiten Eingang eines ersten Addierers/Subtrahierers (add 1) und mit einem ersten und einem zweiten Eingang eines ersten logischen Blocks (mux A/B) verbunden sind, wobei ein Ausgang des ersten Addierers/Subtrahierers (add 1) mit einem dritten Eingang des ersten logischen Blocks (mux A/B) verbunden ist, wobei ein Ausgang des ersten logischen Blocks (mux A/B) den ersten Ausgang (S0) des Operatorblocks bildet,
wobei der vierte Eingang (D) des Operatorblocks mit einem ersten Eingang eines zweiten Addierers/Subtrahierers (add 2) und mit einem ersten Eingang eines zweiten logischen Blocks (mux D/E) verbunden ist, wobei der fünfte Eingang (E) des Operatorblocks mit einem ersten Eingang eines dritten logischen Blocks (mux E/S) verbunden ist, wobei ein Ausgang des dritten logischen Blocks (mux E/S) mit einem zweiten Eingang des zweiten Addierers/ Subtrahierers (add 2) und mit einem zweiten Eingang des zweiten logischen Blocks (mux D/E) verbunden ist, wobei ein Ausgang des zweiten Addierers/Subtrahierers (add 2) mit einem dritten Eingang des zweiten logischen Blocks (mux D/E) verbunden ist, wobei ein Ausgang des zweiten logischen Blocks (mux D/E) den zweiten Ausgang (S1) des Operatorblocks bildet,

wobei der dritte Eingang (C) des Operatorblocks und der Ausgang des ersten logischen Blocks (mux A/B) jeweils mit einem ersten und einem zweiten Eingang eines vierten logischen Blocks (mux ABC) verbunden sind, wobei ein erster und ein zweiter Ausgang des vierten logischen Blocks (mux ABC) jeweils mit einem ersten und einem zweiten Eingang eines dritten Addierers/Subtrahierers (add 3) verbunden sind, wobei ein Ausgang des dritten Addierers/ Subtrahierers (add 3) mit einem zweiten Eingang des dritten logischen Blocks (mux E/S) verbunden ist und den dritten Ausgang (S) des Operatorblocks bildet.

3. Rekonfigurierbares Modul nach Anspruch 2, **dadurch gekennzeichnet, dass** es Mittel aufweist, damit der Ausgang (S0) des ersten logischen Blocks (mux A/B) und der Ausgang (S1) des zweiten logischen Blocks (mux D/E) jeweils in Abhängigkeit des Zeichens der Subtraktion (A-B) des zweiten Eingangs (B) vom ersten Eingang (A) des ersten Addierers/Subtrahierers (add 1) und in Abhängigkeit des Zeichens der Subtraktion (D-E oder D-S) des zweiten Eingangs (E oder S) vom ersten Eingang (D) des zweiten Addierers/Subtrahierers (add 2) bestimmbar sind.

4. Rekonfigurierbares Modul nach einem der vorangehenden Ansprüche, **dadurch gekennzeichnet, dass** es zwei Eingänge (I, 1_ch), zwei Ausgänge (O, O_ch), einen fünften logischen Block (mux I) und einen sechsten logischen Block (mux O) aufweist, wobei der erste Eingang (I) des rekonfigurierbaren Moduls mit einem ersten Eingang des fünften logischen Blocks (mux I) und mit einem ersten Eingang des sechsten logischen Blocks (mux O) verbunden ist, wobei der zweite Eingang (1_ch) des rekonfigurierbaren Moduls mit einem zweiten Eingang des fünften logischen Blocks (mux I) verbunden ist, wobei ein erster, ein zweiter und ein dritter Ausgang des fünften logischen Blocks (mux I) jeweils mit dem ersten, dem zweiten und dem vierten Eingang (A, B, D) des Operatorblocks verbunden sind, wobei der erste, zweite und dritte Ausgang (S0, S1, S) des Operatorblocks jeweils mit einem zweiten, einem dritten und einem vierten Eingang des sechsten logischen Blocks (mux O) verbunden sind, wobei ein Ausgang des sechsten logischen Blocks (mux O) den ersten Ausgang (O) des rekonfigurierbaren Moduls bildet und ein vierter Ausgang des fünften logischen Blocks (mux I) den zweiten Ausgang (O_ch) des rekonfigurierbaren Moduls bildet, wobei dieser zweite Ausgang (O_ch) imstande ist, mit dem zweiten Eingang (1_ch) eines zweiten rekonfigurierbaren Moduls nach vorliegendem Anspruch verbunden zu sein.

5. Rekonfigurierbares Modul nach Anspruch 4, **dadurch gekennzeichnet, dass** es einen FIFO-Puffer und einen siebenten logischen Block (mux B) aufweist, wobei der zweite Ausgang des fünften logischen Blocks (mux I) mit einem ersten Eingang des siebenten logischen Blocks (mux B) verbunden ist, wobei ein Ausgang des siebenten logischen Blocks (mux B) mit dem zweiten Eingang (B) des Operatorblocks verbunden ist, wobei der erste Ausgang (S0) des Operatorblocks mit einem Eingang des FIFO-Puffers verbunden ist, wobei ein Ausgang des FIFO-Puffers mit einem zweiten Eingang des siebenten logischen Blocks (mux B) und mit einem fünften Eingang des sechsten logischen Blocks (mux O) verbunden ist.

6. Rekonfigurierbares Modul nach einem der Ansprüche 4 oder 5, **dadurch gekennzeichnet, dass** es einen achten, einen neunten und einen zehnten logischen Block (mux A, mux D, mux E) umfasst, wobei der erste und dritte Ausgang des fünften logischen Blocks (mux I) jeweils mit einem ersten Eingang des achten logischen Blocks (mux A) und mit einem ersten Eingang des neunten logischen Blocks (mux D) verbunden sind, wobei der dritte Ausgang (S) des Operatorblocks mit einem zweiten Eingang des achten logischen Blocks (mux A), mit einem zweiten Eingang des neunten logischen Blocks (mux D) und mit dem dritten Eingang (C) des Operatorblocks verbunden ist, wobei der zweite und dritte Ausgang (S1, S) des Operatorblocks jeweils mit einem ersten und mit einem zweiten Eingang des zehnten logischen Blocks (mux E) verbunden sind, wobei ein Ausgang des zehnten logischen Blocks (mux E) mit dem fünften Eingang (E) des Operatorblocks verbunden ist.

7. Rekonfigurierbares Modul nach einem der vorangehenden Ansprüche, **dadurch gekennzeichnet, dass** es ein Datenregister (reg C) und einen elften logischen Block (mux C) umfasst, wobei der dritte Ausgang (S) des Operatorblocks und das Datenregister (reg C) jeweils mit einem ersten und einem zweiten Eingang des elften logischen Blocks (mux C) verbunden sind, wobei ein Ausgang des elften logischen Blocks (mux C) mit dem dritten Eingang (C) des Operatorblocks verbunden ist.

8. Verfahren zur Umsetzung eines rekonfigurierbaren Moduls nach einem der vorangehenden Ansprüche, **dadurch gekennzeichnet, dass** es einen Schritt umfasst, der darin besteht, ausgehend von einem Originalbild, das M Zeilen und N Spalten von Pixeln p(m,n) umfasst, wobei M und N positive ganze Zahlen sind, zu bestimmen

- entweder ein Integralbild,
- oder ein erodiertes Bild,
- oder ein Dilatationsbild,

- oder ein Manhattan-Distanzbild,
- oder eine Projektion gemäß den Zeilen und eine Projektion gemäß den Spalten des Originalbilds,
in Abhängigkeit des Operationstyps von Addierern/Subtrahierern, die zum Operatorblock gehören und von Verbindungen, die zwischen Eingängen und Ausgängen logischer Blöcke, die zum Operatorblock gehören, hergestellt sind, wobei das Integralbild, das erodierte Bild, das Dilatationsbild und das Manhattan-Distanzbild dieselbe Dimension wie das Originalbild haben.

9. Verfahren nach Anspruch 8, das ein rekonfigurierbares Modul nach den Ansprüchen 1 und 4 bis 6 umsetzt, **dadurch gekennzeichnet, dass** jedem Pixel p(m,n) des Originalbilds eine Wertigkeit wo(m,n) zugeordnet ist und jedem Pixel p(m,n) des Integralbilds eine Wertigkeit wi(m,n) zugeordnet ist, wobei die Bestimmung des Integralbilds die folgenden Schritte aufweist:

- Definieren eines Zwischenbilds derselben Größe wie das Originalbild, wobei jedem Pixel p(m,n) des Zwischenbilds eine Wertigkeit wii(m,n) zugeordnet ist,
- Initialisieren der Wertigkeiten wii(1,n) der Pixel p(1,n) der ersten Zeile (m=1) des Zwischenbilds,
- Wiederholen der folgenden Schritte für n Variant von 2 bis N:

o Wiederholen der folgenden Schritte für m Variant von 2 bis M, wobei die Wertigkeiten wo(m,n) über den ersten Eingang (I) des rekonfigurierbaren Moduls eingespeist werden, wobei der fünfte und achte logische Block (mux I, mux A) den ersten Eingang (I) des rekonfigurierbaren Moduls mit dem ersten Eingang (A) des Operatorblocks verbinden, wobei der Operatorblock eine Addition der Wertigkeiten wo(m,n) und wii(m-1,n) durchführt, wobei der sechste logische Block (mux O) den ersten Ausgang (S0) des Operatorblocks mit dem ersten Ausgang (O) des rekonfigurierbaren Moduls verbindet, wobei der siebente logische Block (mux B) den Ausgang des FIFO-Puffers mit dem zweiten Eingang (B) des Operatorblocks verbindet:

• Addieren der Wertigkeit wo(m,n) der Pixel p(m,n) des Originalbilds mit der Wertigkeit wii(m-1,n) der Pixel p(m-1,n) des Zwischenbilds,
• Speichern der Ergebnisse der Additionen im FIFO-Puffer, wobei der FIFO-Puffer die Größe M-1 hat,

- Initialisieren der Wertigkeiten wi(m,1) der Pixel p(m,1) der ersten Spalte (n=1) des Integralbilds,
- Wiederholen der folgenden Schritte für m Variant von 2 bis M:

o Wiederholen der folgenden Schritte für n Variant von 2 bis N, wobei die Wertigkeiten wii(m,n) über den ersten Eingang (I) des rekonfigurierbaren Moduls eingespeist werden, wobei der fünfte und achte logische Block (mux I, mux A) den ersten Eingang (I) des rekonfigurierbaren Moduls mit dem ersten Eingang (A) des Operatorblocks verbinden, wobei der Operatorblock die Addition der Wertigkeiten wii(m,n) und wi(m, n-1) durchführt, wobei der sechste logische Block (mux O) den ersten Ausgang (S0) des Operatorblocks mit dem ersten Ausgang (O) des rekonfigurierbaren Moduls verbindet, wobei der siebente logische Block (mux B) den Ausgang des FIFO-Puffers mit dem zweiten Eingang (B) des Operatorblocks verbindet:

• Addieren der Wertigkeit wii(m,n) der Pixels p(m,n) des Zwischenbilds mit der Wertigkeit wi(m,n-1) der Pixel p(m,n-1) des Integralbilds,
• Speichern der Ergebnisse der Additionen im FIFO-Puffer, wobei der FIFO-Puffer die Größe N-1 hat.

10. Verfahren nach einem der Ansprüche 8 oder 9, das ein rekonfigurierbares Modul nach einem der Ansprüche 1 und 4 bis 6 umsetzt, **dadurch gekennzeichnet, dass** jedem Pixel p(m,n) des Originalbilds eine Wertigkeit wo(m,n) zugeordnet ist und jedem Pixel p(m,n) des erodierten Bilds eine Wertigkeit we(m,n) zugeordnet ist, wobei die Bestimmung des erodierten Bilds durch ein strukturierendes Element der Größe 3x3 die folgenden Schritte aufweist:

- Zerlegen des strukturierenden Elements in ein erstes strukturierendes Unterelement der Größe 1x3 und in ein zweites strukturierendes Unterelement der Größe 3x1,
- Definieren eines Zwischenbilds derselben Größe wie das Originalbild, wobei jedem Pixel p(m,n) des Zwischenbilds eine Wertigkeit wie(m,n) zugeordnet ist,
- Wiederholen der folgenden Schritte für m Variant von 1 bis M:

o Wiederholen der folgenden Schritte für n Variant von 1 bis N:

• Zuweisen des Minimums der Wertigkeiten wo(x,y) der Pixel p(x,y), die zum ersten strukturierenden Unterelement gehören, das auf das betreffende Pixel p(m,n) zentriert ist, an die Wertigkeit wie(m,n),

- Wiederholen der folgenden Schritte für n Variant von 1 bis N:

  o Wiederholen der folgenden Schritte für m Variant von 1 bis M:

   • Zuweisen des Minimums der Wertigkeiten wie(x,y) der Pixel p(x,y), die zum zweiten strukturierenden Unterelement gehören, das auf das betreffende Pixel p(m,n) zentriert ist, an die Wertigkeit we(m,n), wobei die Wertigkeiten wo(x,y) oder wie(x,y) über den ersten Eingang (I) des rekonfigurierbaren Moduls eingespeist werden, wobei der fünfte logische Block (mux I) schrittweise den ersten Eingang (I) des rekonfigurierbaren Moduls mit dem ersten Eingang (A) des Operatorblocks über den achten logischen Block (mux A), mit dem zweiten Eingang (B) des Operatorblocks über den siebenten logischen Block (mux B) und mit dem vierten Eingang (D) des Operatorblocks über den neunten logischen Block (mux D) verbindet, wobei der zehnte logische Block (mux E) den dritten Ausgang (S) mit dem fünften Eingang (E) des Operatorblocks verbindet, wobei der Operatorblock das Minimum der Wertigkeiten wo(x,y) oder wie(x,y) der Pixel p(x,y) bestimmt, die zum ersten oder zum zweiten strukturierenden Unterelement gehören, das auf das Pixel p(m,n) zentriert ist, wobei der sechste logische Block (mux O) den zweiten Ausgang (S1) des Operatorblocks mit dem ersten Ausgang (O) des rekonfigurierbaren Moduls verbindet.

**11.** Verfahren nach Anspruch 10, das ein rekonfigurierbares Modul nach den Ansprüchen 1 bis 6 umsetzt, **dadurch gekennzeichnet, dass** die Zuweisung an die Wertigkeit wie(m,n) oder we(m,n) des Minimums der Wertigkeiten wo(x,y) oder wie(x,y) der Pixels p(x,y), die zum ersten oder zum zweiten strukturierenden Unterelement gehören, die folgenden Schritte umfasst:

  - Subtrahieren des zweiten Eingangs (B) vom ersten Eingang (A) des ersten Addierers/Subtrahierers (add 1),
  - Aufbauen einer Verbindung zwischen dem ersten oder dem zweiten Eingang (A, B) und dem Ausgang des ersten logischen Blocks (mux A/B) in Abhängigkeit des Vorzeichens des Ergebnisses der Subtraktion (A-B),
  - Aufbauen einer Verbindung zwischen dem zweiten Eingang und dem ersten Ausgang des vierten logischen Blocks (mux ABC),
  - Addieren oder Subtrahieren des ersten Eingangs des dritten Addierers/Subtrahierers (add 3) mit dem Wert null,
  - Aufbauen einer Verbindung zwischen dem ersten Eingang und dem Ausgang des dritten logischen Blocks (mux E/S),
  - Subtrahieren des zweiten Eingangs (E=S=A oder E=S=B) vom ersten Eingang (D) des zweiten Addierers/Subtrahierers (add 2),
  - Aufbauen einer Verbindung zwischen dem ersten oder dem zweiten Eingang (D, E=S=A oder E=S=B) und dem Ausgang des zweiten logischen Blocks (mux D/E) in Abhängigkeit des Vorzeichens des Ergebnisses der zweiten Subtraktion (D-E).

**12.** Verfahren nach einem der Ansprüche 8 bis 11, das ein rekonfigurierbares Modul nach einem der Ansprüche 1 und 4 bis 6 umsetzt, **dadurch gekennzeichnet, dass** jedem Pixel p(m,n) des Originalbilds eine Wertigkeit wo(m,n) zugeordnet ist und jedem Pixel p(m,n) des Dilatationsbilds eine Wertigkeit wf(m,n) zugeordnet ist, wobei die Bestimmung des Dilatationsbilds durch ein strukturierendes Element der Größe 3x3 die folgenden Schritte aufweist:

  - Zerlegen des strukturierenden Elements in ein erstes strukturierendes Unterelement der Größe 1x3 und in ein zweites strukturierendes Unterelement der Größe 3x1,
  - Definieren eines Zwischenbilds derselben Größe wie das Originalbild, wobei jedem Pixel p(m,n) des Zwischenbilds eine Wertigkeit wif(m,n) zugeordnet ist,
  - Wiederholen der folgenden Schritte für m Variant von 1 bis M:

   o Wiederholen der folgenden Schritte für n Variant von 1 bis N:

    • Zuweisen des Maximums der Wertigkeiten wo(x,y) der Pixel p(x,y), die zum ersten strukturierenden Unterelement gehören, das auf das betreffende Pixel p(m,n) zentriert ist, an die Wertigkeit wif(m,n),

  - Wiederholen der folgenden Schritte für n Variant von 1 bis N:

   o Wiederholen der folgenden Schritte für m Variant von 1 bis M:

• Zuweisen des Maximums der Wertigkeiten wif(x,y) der Pixel p(x,y), die zum zweiten strukturierenden Unterelement gehören, das auf das betreffende Pixel p(m,n) zentriert ist, an die Wertigkeit wf(m,n), wobei die Wertigkeiten wo(x,y) oder wie(x,y) über den ersten Eingang (I) des rekonfigurierbaren Moduls eingespeist werden, wobei der fünfte logische Block (mux I) schrittweise den ersten Eingang (I) des rekonfigurierbaren Moduls mit dem ersten Eingang (A) des Operatorblocks über den achten logischen Block (mux A), mit dem zweiten Eingang (B) des Operatorblocks über den siebenten logischen Block (mux B) und mit dem vierten Eingang (D) des Operatorblocks über den neunten logischen Block (mux D) verbindet, wobei der zehnte logische Block (mux E) den dritten Ausgang (S) mit dem fünften Eingang (E) des Operatorblocks verbindet, wobei der Operatorblock das Maximum der Wertigkeiten wo(x,y) oder wif(x,y) der Pixel p(x,y) bestimmt, die zum ersten oder zum zweiten strukturierenden Unterelement gehören, das auf das Pixel p(m,n) zentriert ist, wobei der sechste logische Block (mux O) den zweiten Ausgang (S1) des Operatorblocks mit dem ersten Ausgang (O) des rekonfigurierbaren Moduls verbindet.

**13.** Verfahren nach Anspruch 12, das ein rekonfigurierbares Modul nach den Ansprüchen 1 bis 6 umsetzt, **dadurch gekennzeichnet, dass** die Zuweisung an die Wertigkeit wif(m,n) oder wf(m,n) des Maximums der Wertigkeiten wo(x,y) oder wif(x,y) der Pixel p(x,y), die zum ersten oder zum zweiten strukturierenden Unterelement gehören, die folgenden Schritte umfasst:

- Subtrahieren des zweiten Eingangs (B) vom ersten Eingang (A) des ersten Addierers/Subtrahierers (add 1),
- Aufbauen einer Verbindung zwischen dem ersten oder dem zweiten Eingang (A, B) und dem Ausgang des ersten logischen Blocks (mux A/B) in Abhängigkeit des Vorzeichens des Ergebnisses der Subtraktion (A-B),
- Aufbauen einer Verbindung zwischen dem zweiten Eingang und dem ersten Ausgang des vierten logischen Blocks (mux ABC),
- Addieren oder Subtrahieren des ersten Eingangs des dritten Addierers/Subtrahierers (add 3) mit dem Wert null,
- Aufbauen einer Verbindung zwischen dem ersten Eingang und dem Ausgang des dritten logischen Blocks (mux E/S),
- Subtrahieren des zweiten Eingangs (E=S=A oder E=S=B) vom ersten Eingang (D) des zweiten Addierers/ Subtrahierers (add 2),
- Aufbauen einer Verbindung zwischen dem ersten oder dem zweiten Eingang (D, E=S=A oder E=S=B) und dem Ausgang des zweiten logischen Blocks (mux D/E) in Abhängigkeit des Vorzeichens des Ergebnisses der zweiten Subtraktion (D-E).

**14.** Verfahren nach einem der Ansprüche 8 bis 13, das ein rekonfigurierbares Modul nach einem der Ansprüche 1 und 4 bis 6 umsetzt, **dadurch gekennzeichnet, dass** jedem Pixel p(m,n) des Originalbilds eine Wertigkeit wo(m,n) zugeordnet ist und jedem Pixel p(m,n) des Distanzbilds eine Wertigkeit wd(m,n) zugeordnet ist, wobei die Wertigkeit wo(m,n) zwei Werte annehmen kann, einen ersten Wert (1), der angibt, dass das betreffende Pixel p(m,n) zu einem Objekt gehört, einen zweiten Wert (0), der angibt, dass das Pixel p(m,n) nicht zu dem Objekt gehört, wobei die Bestimmung des Distanzbilds die folgenden Schritte umfasst:

- Definieren eines Zwischenbilds derselben Größe wie das Originalbild, wobei jedem Pixel p(m,n) des Zwischenbilds eine Wertigkeit wid(m,n) zugeordnet ist,
- Definieren eines ersten strukturierenden Elements, das aus drei Pixeln zusammengesetzt ist, einem zentralen Pixel p(m,n), einem Pixel p(m,n-1), das sich in derselben Zeile wie das zentrale Pixel p(m,n) in der vorhergehenden Spalte befindet und einem Pixel p(m-1,n), das sich in derselben Spalte wie das zentrale Pixel p(m,n) in der vorhergehenden Zeile befindet,
- Wiederholen der folgenden Schritte für m Variant von 1 bis M:

o Wiederholen der folgenden Schritte für n Variant von 1 bis N, wobei der siebente logische Block (mux B) den Ausgang des FIFO-Puffers mit dem zweiten Eingang (B) des Operatorblocks verbindet, wobei der achte logische Block (mux A) den dritten Ausgang (S) mit dem ersten Eingang (A) des Operatorblocks verbindet:

• Bestimmen, ob das zentrale Pixel p(m,n) zum Objekt gehört,
• wenn das der Fall ist, Zuweisen des Werts null an die Wertigkeit wid(m,n), wobei der sechste logische Block (mux O) den ersten Eingang (I) des rekonfigurierbaren Moduls mit dem ersten Ausgang (O) des rekonfigurierbaren Moduls verbindet,
• wenn das nicht der Fall ist, Zuweisen des Minimums der um eine Einheit erhöhten Wertigkeiten wid

(m,n-1) ($V_1$) und wid(m-1,n) ($B_1$) an die Wertigkeit wid(m,n), wobei der sechste logische Block (mux O) den dritten Ausgang (S) des Operatorblocks mit dem ersten Ausgang (O) des rekonfigurierbaren Moduls verbindet,

- Definieren eines zweiten strukturierenden Elements, das aus drei Pixeln zusammengesetzt ist, einem zentralen Pixel p(m,n), einem Pixel p(m+1,n), das sich in derselben Spalte wie das zentrale Pixel p(m,n) in der nächsten Zeile befindet und einem Pixel p(m,n+1), das sich in derselben Zeile wie das zentrale Pixel in der folgenden Spalte befindet,
- Wiederholen der folgenden Schritte für m Variant von M bis 1:

  ◦ Wiederholen der folgenden für n Variant von N bis 1, wobei der fünfte und neunte logische Block (mux I, mux D) den ersten Eingang (I) des rekonfigurierbaren Moduls mit dem vierten Eingang (D) des Operatorblocks verbinden, wobei der sechste logische Block (mux O) den zweiten Ausgang (S1) des Operatorblocks mit dem ersten Ausgang (O) des rekonfigurierbaren Moduls verbindet, wobei der siebente logische Block (mux B) den Ausgang des FIFO-Puffers mit dem zweiten Eingang (B) des Operatorblocks verbindet, wobei der achte logische Block (mux A) den dritten Ausgang (S) mit dem ersten Eingang (A) des Operatorblocks verbindet:
  • Zuweisen des Minimums der Wertigkeiten wid(m,n) (r), wd(m+1,n)+1 ($B_2$+1) und wd(m,n+1)+1 ($V_2$+1) an die Wertigkeit wd(m,n) des zentralen Pixels p(m,n).

15. Verfahren nach Anspruch 14, das ein rekonfigurierbares Modul nach den Ansprüchen 1 bis 7 umsetzt, **dadurch gekennzeichnet, dass** die Zuweisung des Minimums der um eine Einheit erhöhten Wertigkeiten wid(m,n-1) ($V_1$) und wid(m-1,n) ($B_1$) an die Wertigkeit wid(m,n) die folgenden Schritte umfasst:

- Subtrahieren des zweiten Eingangs (B=$B_1$) vom ersten Eingang (A=$V_1$) des ersten Addierers/Subtrahierers (add 1),
- Aufbauen einer Verbindung zwischen dem ersten oder dem zweiten Eingang (A, B) und dem Ausgang des ersten logischen Blocks (mux A/B) in Abhängigkeit des Vorzeichens des Ergebnisses der Subtraktion (A-B),
- Aufbauen einer Verbindung zwischen dem zweiten Eingang (A oder B) und dem ersten Ausgang und zwischen dem ersten Eingang (C) und dem zweiten Ausgang des vierten logischen Blocks (mux ABC),
- Addieren des ersten Eingangs des dritten Addierers/Subtrahierers (add 3) mit dem Wert "eins", wobei der elfte logische Block (mux C) das Datenregister (reg C) mit dem dritten Eingang (C) des Operatorblocks verbindet.

16. Verfahren nach einem der Ansprüche 14 oder 15, das ein rekonfigurierbares Modul nach einem der Ansprüche 1 bis 7 umsetzt, **dadurch gekennzeichnet, dass** die Zuweisung des Minimums der Wertigkeiten wid(m,n) (r), wd(m+1,n)+1 ($B_2$+1) und wd(m,n+1)+1 ($V_2$+1) an die Wertigkeit wd(m,n) die folgenden Schritte umfasst:

- Subtrahieren des zweiten Eingangs (B=$B_2$) vom ersten Eingang (A=$V_2$) des ersten Addierers/Subtrahierers (add 1),
- Aufbauen einer Verbindung zwischen dem ersten oder dem zweiten Eingang (A, B) und dem Ausgang des ersten logischen Blocks (mux A/B) in Abhängigkeit des Vorzeichens des Ergebnisses der Subtraktion (A-B),
- Aufbauen einer Verbindung zwischen dem zweiten Eingang (A oder B) und dem ersten Ausgang und zwischen dem ersten Eingang (C) und dem zweiten Ausgang des vierten logischen Blocks (mux ABC),
- Addieren des ersten Eingangs des dritten Addierers/Subtrahierers (add 3) mit dem Wert "eins", wobei der elfte logische Block (mux C) das Datenregister (reg C) mit dem dritten Eingang (C) des Operatorblocks verbindet,
- Aufbauen einer Verbindung zwischen dem Ausgang des dritten Addierers/Subtrahierers (add 3) und dem zweiten Eingang des zweiten Addierers/Subtrahierers (add 2) über den dritten logischen Block (mux E/S),
- Subtrahieren des zweiten Eingangs ($B_2$+1 oder $V_2$+1) vom ersten Eingang (D=r) des zweiten Addierers/ Subtrahierers (add 2),
- Aufbauen einer Verbindung zwischen dem ersten oder dem zweiten Eingang (r, $B_2$+1 oder $V_2$+1) und dem Ausgang des zweiten logischen Blocks (mux D/E) in Abhängigkeit des Vorzeichens des Ergebnisses der Subtraktion (r-($B_2$+1 oder r-($V_2$+1)).

17. Verfahren nach einem der Ansprüche 8 bis 16, das ein rekonfigurierbares Modul nach Anspruch 1 umsetzt, **dadurch gekennzeichnet, dass** jedem Pixel p(m,n) des Originalbilds eine Wertigkeit wo(m,n) zugeordnet ist, wobei die Bestimmung der Projektionen gemäß den Zeilen und gemäß den Spalten des Originalbilds die folgenden Schritte umfasst:

- Definieren einer Projektionszeile, die dieselbe Anzahl N von Spalten wie die Zeilen des Originalbilds aufweist und einer Projektionsspalte, die dieselbe Anzahl M von Zeilen wie die Spalten des Originalbilds aufweist, wobei jedem Pixel $p(X,n)$ der Projektionszeile und jedem Pixel $p(m,Y)$ der Projektionsspalte jeweils eine Wertigkeit $wp(X,n)$ und $wp(m,Y)$ zugeordnet ist,
- Wiederholen der folgenden Schritte für m Variant von 1 bis M:

  ◦ Wiederholen der folgenden Schritte für n Variant von 1 bis N:

    • Addieren der Wertigkeit $wp(m,Y)$ der Pixel $p(m,Y)$ der Projektionsspalte mit der Wertigkeit $wo(m,n)$ der Pixel $p(m,n)$ des Originalbilds,
    • Addieren der Wertigkeit $wp(X,n)$ der Pixel $p(X,n)$ der Projektionszeile mit der Wertigkeit $wo(m,n)$ der Pixel $p(m,n)$ des Originalbilds.

Image originale

# FIG.1a

Image intégrale

# FIG.1b

Image intégrale

# FIG.2

Image originale

# FIG.3a

|  | 0 | 0 | 0 | 0 |
|---|---|---|---|---|
| | 1 | 4 | 2 | 5 |
| | 8 | 4 | 11 | 8 |
| | 10 | 12 | 15 | 14 |
| | 16 | 21 | 22 | 15 |
| | 19 | 25 | 27 | 23 |

Image intermédiaire

# FIG.3b

| O | | | | |
|---|---|---|---|---|
| 0 | 1 | 5 | 7 | 12 |
| 0 | 8 | 12 | 23 | 31 |
| 0 | 10 | 22 | 37 | 51 |
| 0 | 16 | 37 | 59 | 74 |
| 0 | 19 | 44 | 71 | 94 |

Image intégrale

# FIG.3c

| 5 | 9 | 2 | 13 |
|---|---|---|---|
| 12 | 4 | 7 | 15 |
| 8 | 6 | 1 | 0 |
| 11 | 7 | 5 | 10 |

Image originale

Fenêtre 3x3

| 1 | 1 | 1 |
|---|---|---|
| 1 | 1 | 1 |
| 1 | 1 | 1 |

Erosion (min)

| 4 | 2 | 2 | 2 |
|---|---|---|---|
| 4 | 1 | 0 | 0 |
| 4 | 1 | 0 | 0 |
| 4 | 1 | 0 | 0 |

Image érodée

Dilatation (max)

| 12 | 12 | 15 | 15 |
|---|---|---|---|
| 12 | 12 | 15 | 15 |
| 12 | 12 | 15 | 15 |
| 11 | 11 | 10 | 10 |

Image dilatée

# FIG.4

FIG. 5

min(X,5,9)

Image originale    min(6,1,0)    Image
intermédiaire

FIG.6a

min(X,5,4)

Image
intermédiaire    min(2,4,0)    Image érodée

FIG.6b

| 0 | 0 | 0 | 0 | 0 |
|---|---|---|---|---|
| 0 | 0 | 0 | 0 | 0 |
| 0 | 0 | 0 | 0 | 0 |
| 0 | 0 | 0 | 0 | 0 |
| 0 | 0 | 0 | 1 | 1 |
| 0 | 1 | 1 | 1 | 0 |
| 0 | 1 | 1 | 1 | 0 |

Image originale binarisée

| 6 | 5 | 5 | 4 | 4 |
|---|---|---|---|---|
| 5 | 4 | 4 | 3 | 3 |
| 4 | 3 | 3 | 2 | 2 |
| 3 | 2 | 2 | 1 | 1 |
| 2 | 1 | 1 | 0 | 0 |
| 1 | 0 | 0 | 0 | 1 |
| 1 | 0 | 0 | 0 | 1 |

Image distance city-block

## FIG.7

| 0 | 0 | 0 | 0 | 0 |
|---|---|---|---|---|
| 0 | 0 | 0 | 0 | 0 |
| 0 | 0 | 0 | 0 | 0 |
| 0 | 0 | 0 | 0 | 0 |
| 0 | 0 | 0 | 1 | 1 |
| 0 | 1 | 1 | 1 | 0 |
| 0 | 1 | 1 | 1 | 0 |

Image originale binarisée

Distance city-block

## FIG.8

101 — Initialisation

102 — wo(m,n)=1 ? — OUI

NON

104 — wid(m,n) ←min($V_1$+1,$B_1$+1)

103 — wid(m,n) ←0

NON — n=N ? — 105

OUI

107 — m=M ? — NON

OUI

106 — n←n+1

108 — Fin

109 — m←m+1 n←1

## FIG.9

O

| 0 | 0 | 0 | 0 | 0 |
|---|---|---|---|---|
| 0 | 1 | 1 | 1 | 0 |
| 1 | 1 | 0 | 0 | 0 |
| 0 | 1 | 1 | 1 | 0 |
| 0 | 0 | 0 | 0 | 0 |

Image originale binarisée

Balayage causal

$V_1$ $B_1$

O

| | FFF7 | FFF7 | FFF7 | FFF7 | FFF7 |
|---|---|---|---|---|---|
| FFF7 | FFF8 | FFF8 | FFF8 | FFF8 | FFF8 |
| FFF7 | FFF8 | 0 | 0 | 0 | 1 |
| FFF7 | 0 | 0 | 1 | 1 | 2 |
| FFF7 | 1 | 0 | 0 | 0 | 1 |
| FFF7 | 2 | 1 | 1 | 1 | 2 |

Image intermédiaire

## FIG.10

201 —

Initialisation

202 —

$$wd(m,n) \leftarrow \min(r, V_2+1, B_2+1)$$

203

NON

n=1 ?

OUI

205 —

m=1 ?

NON

OUI

204

n ← n-1

206

Fin

207

m ← m-1
n ← N

## FIG.11

O ⇄ O

| FFFE | FFFE | FFFE | FFFE | FFFE |
|------|------|------|------|------|
| FFFE | 0 | 0 | 0 | 1 |
| 0 | 0 | 1 | 1 | 2 |
| 1 | 0 | 0 | 0 | 1 |
| 2 | 1 | 1 | 1 | 2 |

Image intermédiaire

Balayage
anticausal

$$\begin{bmatrix} r & V_2 \\ B_2 & \end{bmatrix}$$

| 2 | 1 | 1 | 1 | 2 | FFFE |
|---|---|---|---|---|------|
| 1 | 0 | 0 | 0 | 1 | FFFE |
| 0 | 0 | 1 | 1 | 2 | FFFE |
| 1 | 0 | 0 | 0 | 1 | FFFE |
| 2 | 1 | 1 | 1 | 2 | FFFE |
| FFFE | FFFE | FFFE | FFFE | FFFE | |

Image distance

## FIG.12

n   Image originale

m

| 0 | 1 | 2 | 3 |
|----|----|----|----|
| 4 | 5 | 6 | 7 |
| 8 | 9 | 10 | 11 |
| 12 | 13 | 14 | 15 |
| 16 | 17 | 18 | 19 |

⇒

| 6 |
|----|
| 22 |
| 38 |
| 54 |
| 70 |

Somme des lignes   FIG.13

| 40 | 45 | 50 | 55 |
|----|----|----|----|

Somme des colonnes

FIG.14

FIG.15

EP 2 329 596 B1

10

20

$I_1$ → Module reconfigurable (1$^{er}$) → $O_1$

$I\_ch_1$ → → $O\_ch_1$

$I_2$ → Module reconfigurable (2$^e$) → $O_2$

$I\_ch_2$ → → $O\_ch_2$

FIG.16